# EUROPEAN PATENT APPLICATION

(11) **EP 4 421 850 A1**
(43) Date of publication of application: **28.08.2024**
(21) Application number: 22883437.0
(22) Date of filing: 12.10.2022
(51) Int. Cl.: H01L 21/304

(54) **SUBSTRATE PROCESSING METHOD AND SUBSTRATE PROCESSING DEVICE**

(30) Priority: 22.10.2021 JP 2021173028; 02.05.2022 JP 2022075874
(71) Applicant: SCREEN Holdings Co., Ltd., Kyoto-shi, Kyoto 602-8585 (JP)
(72) Inventor: TANAKA, Tomoya, Kyoto-shi, Kyoto 602-8585 (JP); TSUKAHARA, Ryuta, Kyoto-shi, Kyoto 602-8585 (JP); OTSUJI, Masayuki, Kyoto-shi, Kyoto 602-8585 (JP); TANAKA, Takayoshi, Kyoto-shi, Kyoto 602-8585 (JP); IWASAKI, Akihisa, Kyoto-shi, Kyoto 602-8585 (JP)
(74) Representative: Kilian Kilian & Partner mbB
(86) International application number: PCT/JP2022/038031
(87) International publication number: WO 2023/068133

(57) **Abstract**

The present invention relates to a substrate treating method and a substrate treating apparatus. The substrate treating method is for treating the substrate. The substrate has a pattern formed on a surface of the substrate. The substrate treating method includes the hydrophilization step, the first supplying step, the solidified film forming step, and the sublimation step. In the hydrophilization step, the hydroxy group is formed on the surface of the substrate. In the first supplying step, the drying auxiliary liquid is supplied to the substrate having the hydroxy group. The drying auxiliary liquid contains the sublimable substance and the first solvent. The sublimable substance contains an organic compound containing an oxime group. In the solidified film forming step, the first solvent evaporates from the drying auxiliary liquid on the substrate. In the solidified film forming step, the solidified film is formed on the substrate. The solidified film contains the sublimable substance. In the sublimation step, the solidified film is sublimated.

## Description

### Technical Field

The present invention relates to a substrate treating method and a substrate treating apparatus. The substrate is, for example, a semiconductor wafer, a substrate for a liquid crystal display, a substrate for an organic electroluminescence (EL), a substrate for a flat panel display (FPD), a substrate for an optical display, a substrate for a magnetic disk, a substrate for an optical disk, a substrate for a magneto-optical disk, a substrate for a photomask, or a substrate for a solar cell.

### Background Art

A substrate treating method for treating a substrate is disclosed in Patent Literature 1. The substrate has a pattern formed on a surface of the substrate. The substrate treating method includes a cleaning step, a replacement step, a supplying step, a solidification step, and a sublimation step. In the cleaning step, a cleaning liquid and a rinse liquid are supplied to the substrate. The cleaning liquid is, for example, SC-1. The rinse liquid is, for example, deionized water. In the replacement step, a replacement liquid is supplied to the substrate. The replacement liquid is, for example, isopropyl alcohol. In the supplying step, a drying auxiliary liquid is supplied to the substrate. The drying auxiliary liquid contains a sublimable substance. The sublimable substance contains a fluorocarbon compound. The drying auxiliary liquid may further contain an organic solvent. In the solidification step, the drying auxiliary liquid is solidified on the substrate. In the solidification step, a solidified film is formed on the substrate. In the sublimation step, the solidified film is sublimated. In the sublimation step, the solidified film is removed from the substrate.

The substrate treating method may further include a hydrophobization step. The hydrophobization step is executed after the replacement step and before the supplying step. In the hydrophobization step, a water repellent is supplied to the substrate. In the hydrophobization step, the water repellent adheres to the substrate.

### Citation List

### Patent Literature

### Patent Literature 1: JP 2018-22861 A

### Summary of Invention

### Technical Problem

In the conventional substrate treating method, a substrate may fail to be appropriately dried. For example, in the conventional substrate treating method, a pattern formed on the substrate may also collapse. For example, when the pattern is fine, the conventional substrate treating method may fail to sufficiently suppress the collapse of the pattern.

The present invention has been made in view of such problems, and an object of the present invention is to provide a substrate treating method and a substrate treating apparatus capable of appropriately drying a substrate.

### Solution to Problem

In order to achieve the above object, the present invention has the following configuration. That is, the present invention is a substrate treating method for treating a substrate having a pattern formed on a surface of the substrate, the substrate treating method including: a hydrophilization step of forming a hydroxy group on the surface of the substrate; a first supplying step of supplying a drying auxiliary liquid containing a sublimable substance and a first solvent to the substrate having the hydroxy group; a solidified film forming step of forming a solidified film containing the sublimable substance on the substrate by evaporating the first solvent from the drying auxiliary liquid on the substrate; and a sublimation step of sublimating the solidified film, wherein the sublimable substance contains an organic compound containing an oxime group.

The substrate treating method is for treating the substrate. The substrate has a pattern formed on a surface of the substrate. The substrate treating method includes the hydrophilization step, the first supplying step, the solidified film forming step, and the sublimation step. In the hydrophilization step, the hydroxy group is formed on the surface of the substrate. In the first supplying step, the drying auxiliary liquid is supplied to the substrate having the hydroxy group. The drying auxiliary liquid contains the sublimable substance and the first solvent. In the solidified film forming step, the first solvent evaporates from the drying auxiliary liquid on the substrate. In the solidified film forming step, the solidified film is formed on the substrate. The solidified film contains the sublimable substance. In the sublimation step, the solidified film is sublimated. The substrate is dried by the sublimation of the solidified film.

Here, the sublimable substance contains the organic compound containing the oxime group. Therefore, in the first supplying step, the drying auxiliary liquid is appropriately supplied to the pattern of the substrate. As a result, in the solidified film forming step, the solidified film is appropriately formed along the pattern of the substrate. The solidified film suitably supports the pattern. The solidified film appropriately prevents the pattern from collapsing. With the pattern suitably protected, the substrate is dried.

As described above, according to the substrate treating method, the substrate is appropriately dried.

It is preferable that in the substrate treating method described above, an ammonia hydrogen peroxide mixture is supplied to the substrate in the hydrophilization step. In the hydrophilization step, the hydroxy group is suitably formed on the surface of the substrate.

It is preferable that the substrate treating method described above further includes an etching step of supplying an etching liquid to the substrate to remove an oxide film on the substrate before the hydrophilization step. The etching step is executed before the hydrophilization step. In the etching step, the etching liquid is supplied to the substrate. In the etching step, the oxide film on the substrate is removed. Therefore, in the hydrophilization step, the hydroxy group is more appropriately formed on the surface of the substrate.

It is preferable that the substrate treating method described above further includes a first rinse step of supplying a first rinse liquid to the substrate after the etching step and before the hydrophilization step. The first rinse step is executed after the etching step and before the hydrophilization step. In the first rinse step, the first rinse liquid is supplied to the substrate. Therefore, in the first rinse step, the etching liquid is suitably removed from the substrate. Therefore, in the hydrophilization step, the hydroxy group is more appropriately formed on the surface of the substrate.

It is preferable that the substrate treating method described above further includes a second rinse step of supplying a second rinse liquid to the substrate after the hydrophilization step and before the first supplying step. The second rinse step is executed after the hydrophilization step and before the first supplying step. In the second rinse step, the second rinse liquid is supplied to the substrate. Therefore, in the second rinse step, the substrate is appropriately cleaned. Therefore, in the first supplying step, the drying auxiliary liquid is more appropriately supplied to the pattern of the substrate.

It is preferable that the substrate treating method described above includes a first replacement step of supplying a first replacement liquid to the substrate after the second rinse step and before the first supplying step. The first replacement step is executed after the second rinse step and before the first supplying step. In the first replacement step, the first replacement liquid is supplied to the substrate. Therefore, in the first replacement step, the second rinse liquid is removed from the substrate. Therefore, in the first supplying step, the drying auxiliary liquid is appropriately supplied to the pattern of the substrate.

It is preferable that in the substrate treating method described above, the substrate is cooled in the solidified film forming step. Therefore, in the solidified film forming step, the formation of the solidified film is further promoted. Therefore, the solidified film is more suitably formed along the pattern. Thus, the substrate is more appropriately dried.

In addition, the present invention is a substrate treating method for treating a substrate having a pattern formed on a surface of the substrate, the substrate treating method including: a hydrophobization step of adhering a water repellent to the surface of the substrate; a second supplying step of supplying a drying auxiliary liquid containing a sublimable substance and a first solvent to the substrate to which the water repellent adheres; a solidified film forming step of forming a solidified film containing the sublimable substance on the substrate by evaporating the first solvent from the drying auxiliary liquid on the substrate; and a sublimation step of sublimating the solidified film, wherein the sublimable substance contains an organic compound containing an oxime group.

The substrate treating method is for treating the substrate. The substrate has a pattern formed on a surface of the substrate. The substrate treating method includes the hydrophobization step, the second supplying step, the solidified film forming step, and the sublimation step. In the hydrophobization step, the water repellent adheres to the surface of the substrate. In the second supplying step, the drying auxiliary liquid is supplied to the substrate to which the water repellent adheres. The drying auxiliary liquid contains the sublimable substance and the first solvent. In the solidified film forming step, the first solvent evaporates from the drying auxiliary liquid on the substrate. In the solidified film forming step, the solidified film is formed on the substrate. The solidified film contains the sublimable substance. In the sublimation step, the solidified film is sublimated. The substrate is dried by the sublimation of the solidified film.

Here, the sublimable substance contains the organic compound containing the oxime group. Therefore, in the second supplying step, the drying auxiliary liquid is appropriately supplied to the pattern of the substrate. As a result, in the solidified film forming step, the solidified film is appropriately formed along the pattern of the substrate. The solidified film suitably supports the pattern. The solidified film appropriately prevents the pattern from collapsing. With the pattern suitably protected, the substrate is dried.

As described above, according to the substrate treating method, the substrate is appropriately dried.

It is preferable that in the substrate treating method described above, a mixed liquid containing the water repellent and a second solvent is supplied to the substrate in the hydrophobization step. In the hydrophobization step, the water repellent contained in the mixed liquid is suitably supplied to the substrate. Therefore, in the hydrophobization step, the water repellent contained in the mixed liquid suitably adheres to the substrate.

It is preferable that the substrate treating method described above further includes a hydrophilization step of forming a hydroxy group on the surface of the substrate before the hydrophobization step. The hydrophilization step is executed before the hydrophobization step. In the hydrophilization step, the hydroxy group is formed on the surface of the substrate. Therefore, in the hydrophobization step, the surface of the substrate has the hydroxy group. Therefore, in the hydrophobization step, the water repellent more suitably adheres to the surface of the substrate.

It is preferable that the substrate treating method described above further includes an etching step of supplying an etching liquid to the substrate to remove an oxide film on the substrate before the hydrophilization step. The etching step is executed before the hydrophilization step. In the etching step, the etching liquid is supplied to the substrate. In the etching step, the oxide film on the substrate is removed. Therefore, in the hydrophilization step, the hydroxy group is appropriately formed on the surface of the substrate.

It is preferable that the substrate treating method described above further includes a first rinse step of supplying a first rinse liquid to the substrate after the etching step and before the hydrophilization step. The first rinse step is executed after the etching step and before the hydrophilization step. In the first rinse step, the first rinse liquid is supplied to the substrate. Therefore, in the first rinse step, the etching liquid is suitably removed from the substrate. Therefore, in the hydrophilization step, the hydroxy group is more appropriately formed on the surface of the substrate.

It is preferable that the substrate treating method described above further includes the second rinse step of supplying the second rinse liquid to the substrate after the hydrophilization step and before the hydrophobization step. The second rinse step is executed after the hydrophilization step and before the hydrophobization step. In the second rinse step, the second rinse liquid is supplied to the substrate. Therefore, in the second rinse step, the substrate is appropriately cleaned. Therefore, in the hydrophobization step, the water repellent more suitably adheres to the substrate.

It is preferable that the substrate treating method described above further includes a second replacement step of supplying a second replacement liquid to the substrate after the second rinse step and before the hydrophobization step. The second replacement step is executed after the second rinse step and before the hydrophobization step. In the second replacement step, the second replacement liquid is supplied to the substrate. Therefore, in the second replacement step, the second rinse liquid is removed from the substrate. Therefore, in the hydrophobization step, the water repellent more suitably adheres to the substrate.

It is preferable that the substrate treating method described above further includes a third replacement step of supplying a third replacement liquid to the substrate after the hydrophobization step and before the second supplying step. The third replacement step is executed after the hydrophobization step and before the second supplying step. In the third replacement step, the third replacement liquid is supplied to the substrate. Therefore, the substrate is appropriately cleaned in the third replacement step. Therefore, in the second supplying step, the drying auxiliary liquid is appropriately supplied to the pattern of the substrate.

It is preferable that in the substrate treating method described above, the sublimable substance does not contain a fluorocarbon compound. In the first supplying step, the drying auxiliary liquid is more appropriately supplied to the pattern of the substrate. In the second supplying step, the drying auxiliary liquid is more appropriately supplied to the pattern of the substrate.

It is preferable that in the substrate treating method described above, the sublimable substance contains at least one of cyclohexanone oxime and pinacoline oxime. In the first supplying step, the drying auxiliary liquid is more appropriately supplied to the pattern of the substrate. In the second supplying step, the drying auxiliary liquid is more appropriately supplied to the pattern of the substrate.

The present invention is a substrate treating apparatus including: a substrate holder that holds a substrate; a hydrophilization unit that forms a hydroxy group on a surface of the substrate held by the substrate holder; and a first supplying unit that supplies a drying auxiliary liquid containing a sublimable substance and a first solvent to the substrate held by the substrate holder, wherein the sublimable substance contains an organic compound containing an oxime group.

The substrate treating apparatus includes the substrate holder, the hydrophilization unit, and the first supplying unit. The substrate holder holds the substrate. The hydrophilization unit forms the hydroxy group on the substrate held by the substrate holder. The first supplying unit supplies the drying auxiliary liquid to the substrate held by the substrate holder. The drying auxiliary liquid contains the sublimable substance and the first solvent. Therefore, when the first supplying unit supplies the drying auxiliary liquid to the substrate, the first solvent evaporates from the drying auxiliary liquid on the substrate. The solidified film is formed on the substrate by the evaporation of the first solvent. The solidified film contains the sublimable substance. Thus, the solidified film is sublimated. The substrate is dried by the sublimation of the solidified film.

Here, the sublimable substance contains the organic compound containing the oxime group. Therefore, the drying auxiliary liquid is appropriately supplied to the pattern of the substrate. As a result, the solidified film is appropriately formed along the pattern of the substrate. The solidified film suitably supports the pattern. The solidified film appropriately prevents the pattern from collapsing. With the pattern suitably protected, the substrate is dried.

As described above, according to the substrate treating apparatus, the substrate is appropriately dried.

It is preferable that the substrate treating apparatus described above includes a cooling unit that cools the substrate. Therefore, the substrate is suitably cooled. Therefore, the substrate is treated more appropriately.

The present invention is a substrate treating apparatus including: a substrate holder that holds a substrate; a hydrophobization unit that adheres a water repellent to a surface of the substrate held by the substrate holder; and a first supplying unit that supplies a drying auxiliary liquid containing a sublimable substance and a first solvent to the substrate held by the substrate holder, wherein the sublimable substance contains an organic compound containing an oxime group.

The substrate treating apparatus includes the substrate holder, the hydrophobization unit, and the first supplying unit. The substrate holder holds the substrate. The hydrophobization unit adheres the water repellent to the surface of the substrate held by the substrate holder. The first supplying unit supplies the drying auxiliary liquid to the substrate held by the substrate holder. The drying auxiliary liquid contains the sublimable substance and the first solvent. Therefore, when the first supplying unit supplies the drying auxiliary liquid to the substrate, the first solvent evaporates from the drying auxiliary liquid on the substrate. The solidified film is formed on the substrate by the evaporation of the first solvent. The solidified film contains the sublimable substance. Thus, the solidified film is sublimated. The substrate is dried by the sublimation of the solidified film.

Here, the sublimable substance contains the organic compound containing the oxime group. Therefore, the drying auxiliary liquid is appropriately supplied to the pattern of the substrate. As a result, the solidified film is appropriately formed along the pattern of the substrate. The solidified film suitably supports the pattern. The solidified film appropriately prevents the pattern from collapsing. With the pattern suitably protected, the substrate is dried.

As described above, according to the substrate treating apparatus, the substrate is appropriately dried.

### Advantageous Effects of Invention

According to the substrate treating method and the substrate treating apparatus of the present invention, the substrate is appropriately dried.

### Brief Description of Drawings

FIG. 1 is a view schematically showing a part of a substrate.
FIG. 2 is a plan view showing an inside of a substrate treating apparatus of the first embodiment.
FIG. 3 is a control block diagram of the substrate treating apparatus.
FIG. 4 is a diagram showing a configuration of a treating unit and a first supplying source.
FIG. 5 is a flowchart showing a procedure of a substrate treating method of the first embodiment.
FIG. 6 is a view schematically showing the substrate in a first supplying step.
FIG. 7 is a view schematically showing the substrate in a solidified film forming step.
FIG. 8 is a view schematically showing the substrate in the solidified film forming step.
FIG. 9 is a view schematically showing the substrate in a sublimation step.
FIG. 10 is a view schematically showing the substrate in the sublimation step.
FIG. 11 is a diagram for describing a mechanism of protection of a pattern.
FIG. 12 is a diagram for describing a mechanism of collapse of a pattern.
FIG. 13 is a diagram showing a configuration of a treating unit and a first supplying source of a second embodiment.
FIG. 14 is a flowchart showing a procedure of a substrate treating method of a second embodiment.
FIG. 15 is a diagram showing a configuration of a treating unit and a first supplying source of a modification.
FIG. 16 is a diagram showing the configuration of the treating unit of the modification.
FIG. 17 is a view schematically showing a substrate in a solidified film forming step of the modification.
FIG. 18 is a view schematically showing the substrate in the solidified film forming step of the modification.

### Description of Embodiments

Hereinafter, a substrate treating method and a substrate treating apparatus of the present invention will be described with reference to the drawings.

### <1. First embodiment>

### <1-1. Substrate>

A substrate W is, for example, a semiconductor wafer, a substrate for a liquid crystal display, a substrate for an organic electroluminescence (EL), a substrate for a flat panel display (FPD), a substrate for an optical display, a substrate for a magnetic disk, a substrate for an optical disk, a substrate for a magneto-optical disk, a substrate for a photomask, or a substrate for a solar cell. The substrate W has a thin flat plate shape. The substrate W has a substantially circular shape in a plan view.

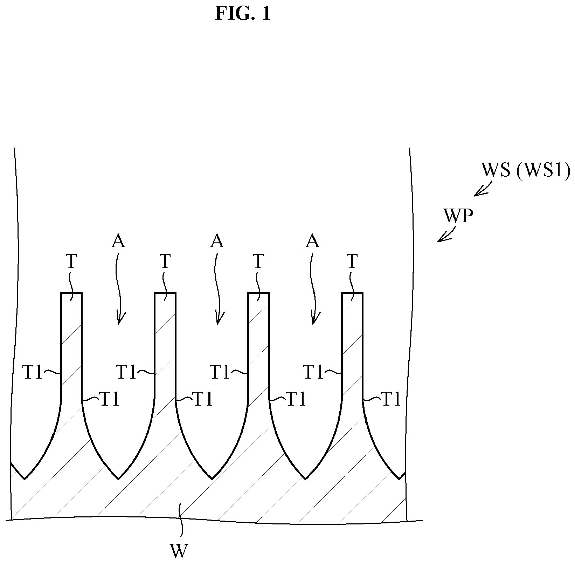

FIG. 1 is a view schematically showing a part of the substrate W. The substrate W has a surface WS. The surface WS includes a pattern WP. The pattern WP is formed on the surface WS.

For example, the surface WS includes a first surface WS1. Although not shown, the surface WS further includes a second surface and a peripheral edge. The second surface is located opposite to the first surface. The peripheral edge is located between the periphery of the first surface and the periphery of the second surface. The pattern WP is formed on the first surface WS1. The first surface WS1 is also referred to as pattern formation surface.

The pattern WP has, for example, an uneven shape. The pattern WP is, for example, at least one of a line-and-space pattern, a hole pattern, and a dot pattern.

The pattern WP includes, for example, a plurality of projections T. The projection T is a part of the substrate W. The projection T is a structure. The projection T has, for example, a columnar shape, a dot shape, a line shape, or a wall shape. The projection T projects, for example, upward of the substrate W. The plurality of projections T is arranged, for example, in the horizontal direction.

The pattern WP includes, for example, a plurality of recesses A. The recess A is a space. The recess A is, for example, at least one of a trench, a void, a pore, and a hole. The hole is also referred to as through hole or via hole. The recess A is, for example, recessed downward. The recess A is, for example, open upward.

The recess A is partitioned by at least one projection T. The recess A is in contact with at least one projection T. The recess A is located on a side of the projection T. For example, the recess A is located between two adjacent projections T. The two adjacent projections T are separated by the recess A.

More specifically, each projection T has a side T1. The side T1 is also referred to as side surface. The side T1 is in contact with the recess A.

The surface WS is formed of, for example, at least one of a film containing silicon and a metal film. The projection T is also formed of, for example, at least one of a film containing silicon and a metal film. The film containing silicon includes at least one of a single crystal silicon film, a polysilicon film, an amorphous silicon film, a SiO2 film, a SiN film, a BSG film, and a TEOS film, for example. The BSG film is a SiO2 film containing boron. The TEOS film is a SiO2 film formed by a CVD method using tetraethoxysilane (TEOS). The metal film contains, for example, at least one of Ti (titanium), W (tungsten), Cu (copper), and Al (aluminum). The metal film includes, for example, one of a TiN film and a W film. The SiO2 film, the BSG film, and the TEOS film are sometimes classified as oxide films. The SiN film and the TiN film are sometimes classified as nitride films.

For example, the projection T is formed of one film. Alternatively, the projection T is formed of a plurality of films. The plurality of films are stacked on each other, for example.

### <1-2. Outline of substrate treating apparatus>

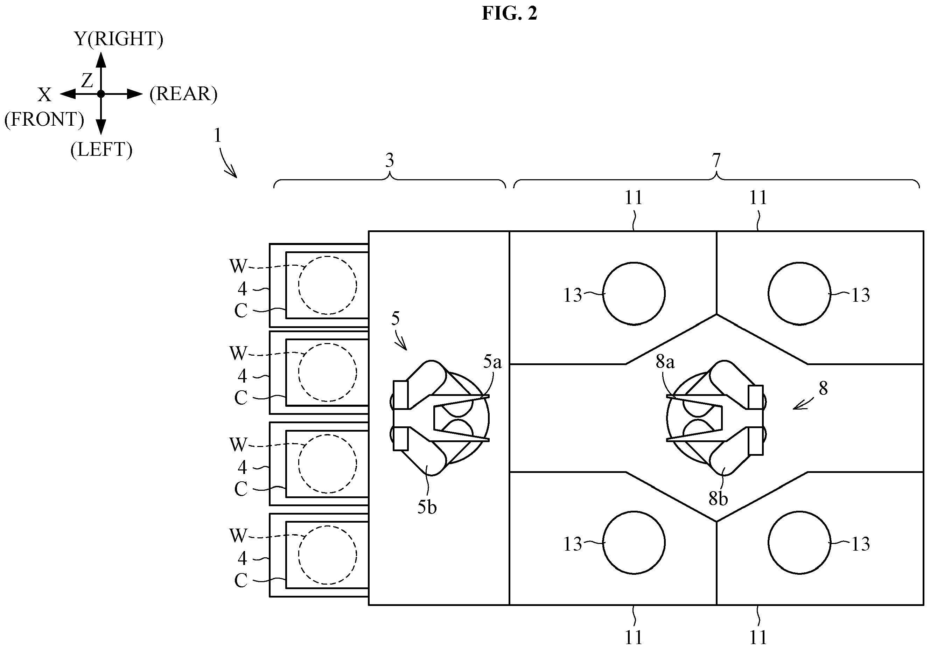

FIG. 2 is a plan view showing an inside of a substrate treating apparatus 1 of the first embodiment. The substrate treating apparatus 1 performs treatment on the substrate W. The treatment in the substrate treating apparatus 1 includes a drying treatment.

The substrate treating apparatus 1 includes an indexer 3 and a treating block 7. The treating block 7 is connected to the indexer 3. The indexer 3 supplies the substrate W to the treating block 7. The treating block 7 performs treatment on the substrate W. The indexer 3 collects the substrate W from the treating block 7.

In the present description, for convenience, a direction in which the indexer 3 and the treating block 7 are arranged is referred to as "front-rear direction X". The front-rear direction X is horizontal. In the front-rear direction X, a direction from the treating block 7 toward the indexer 3 is referred to as "front". The direction opposite to the front is referred to as "rear". A horizontal direction orthogonal to the front-rear direction X is referred to as "width direction Y". One direction of the "width direction Y" is referred to as "right" as appropriate. A direction opposite to the right is referred to as "left". A direction perpendicular to the horizontal direction is referred to as "vertical direction Z". In the drawings, FRONT, REAR, RIGHT, LEFT, UP, and DOWN are appropriately indicated for reference.

The indexer 3 includes a plurality of (for example, four) carrier platforms 4. Each carrier platform 4 mounts one carrier C. The carrier C accommodates a plurality of substrates W. The carrier C is, for example, a front opening unified pod (FOUP), a standard mechanical interface (SMIF), or an open cassette (OC).

The indexer 3 includes a transport mechanism 5. The transport mechanism 5 is disposed behind the carrier platform 4. The transport mechanism 5 transports the substrate W. The transport mechanism 5 is capable of accessing the carrier C mounted on the carrier platform 4. The transport mechanism 5 includes a hand 5a and a hand driving unit 5b. The hand 5a supports the substrate W. The hand driving unit 5b is connected to the hand 5a. The hand driving unit 5b moves the hand 5a. The hand driving unit 5b moves the hand 5a in the front-rear direction X, the width direction Y, and the vertical direction Z, for example. The hand driving unit 5b rotates the hand 5a in a horizontal plane, for example.

The treating block 7 includes a transport mechanism 8. The transport mechanism 8 transports the substrate W. The transport mechanism 8 and the transport mechanism 5 can transfer the substrate W to each other. The transport mechanism 8 includes a hand 8a and a hand driving unit 8b. The hand 8a supports the substrate W. The hand driving unit 8b is connected to the hand 8a. The hand driving unit 8b moves the hand 8a. The hand driving unit 8b moves the hand 8a in the front-rear direction X, the width direction Y, and the vertical direction Z, for example. The hand driving unit 8b rotates the hand 8a in a horizontal plane, for example.

The treating block 7 includes a plurality of treating units 11. Each treating unit 11 is disposed on a side of the transport mechanism 8. Each treating unit 11 performs treatment on the substrate W.

The treating unit 11 includes a substrate holder 13. The substrate holder 13 holds the substrate W.

The transport mechanism 8 is accessible to each treating unit 11. The transport mechanism 8 can transfer the substrate W to the substrate holder 13. The transport mechanism 8 can take the substrate W from the substrate holder 13.

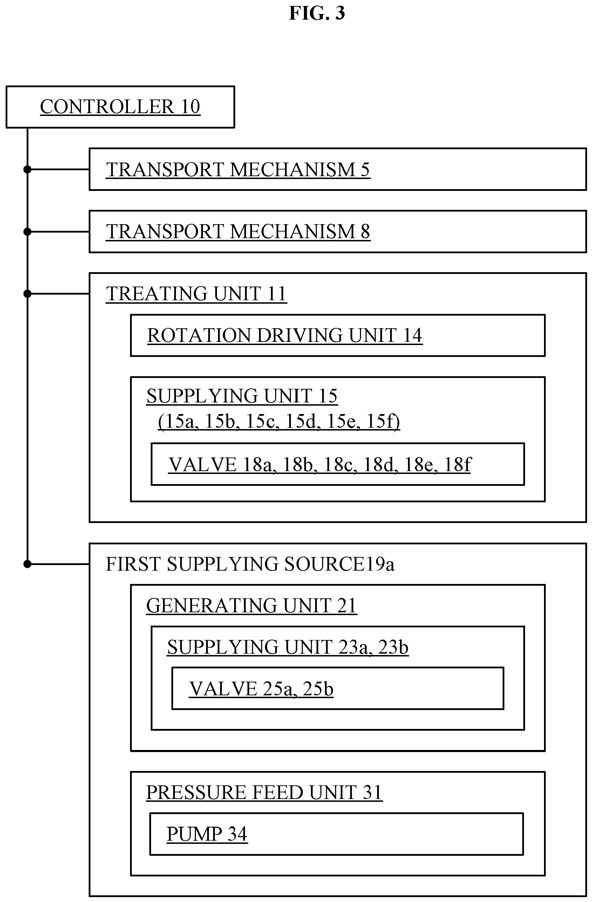

FIG. 3 is a control block diagram of the substrate treating apparatus 1. The substrate treating apparatus 1 includes a controller 10. The controller 10 is capable of communicating with the transport mechanisms 5 and 8 and the treating unit 11. The controller 10 controls the transport mechanisms 5 and 8 and the treating unit 11.

The controller 10 is implemented by a central processing unit (CPU) that executes various processes, a random-access memory (RAM) that serves as a work area for arithmetic processes, a storage medium such as a fixed disk, and the like. The controller 10 contains various types of information stored in the storage medium in advance. The information stored in the controller 10 includes transport condition information for controlling the transport mechanisms 5, 8, for example. The information stored in the controller 10 includes processing condition information for controlling the treating unit 11, for example. The processing condition information is also referred to as processing recipe.

An operation example of the substrate treating apparatus 1 will be briefly described.

The indexer 3 supplies the substrate W to the treating block 7. Specifically, the transport mechanism 5 transfers the substrate W from the carrier C to the transport mechanism 8 of the treating block 7.

The transport mechanism 8 distributes the substrate W to the treating unit 11. Specifically, the transport mechanism 8 transports the substrate W from the transport mechanism 5 to the substrate holder 13 of each treating unit 11.

The treating unit 11 treats the substrate W held by the substrate holder 13. The treating unit 11 performs, for example, the drying treatment on the substrate W.

After the treating unit 11 treats the substrate W, the transport mechanism 8 collects the substrate W from each treating unit 11. Specifically, the transport mechanism 8 takes the substrate W from each substrate holder 13. The transport mechanism 8 then passes the substrate W to the transport mechanism 5.

The indexer 3 collects the substrate W from the treating block 7. Specifically, the transport mechanism 5 transports the substrate W from the transport mechanism 8 to the carrier C.

### <1-3. Configuration of treating unit 11>

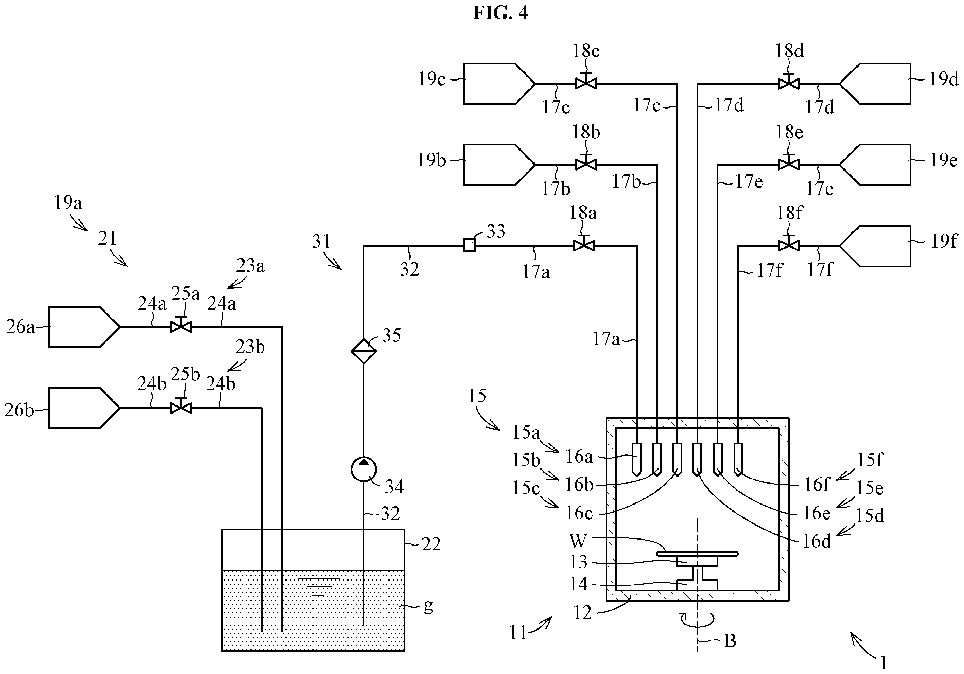

FIG. 4 is a diagram showing the configuration of the treating unit 11. Each treating unit 11 has the same structure. The treating unit 11 is classified as a single wafer type. That is, each treating unit 11 treats only one substrate W at a time.

The treating unit 11 includes a housing 12. The housing 12 has a substantially box shape. The substrate W is treated inside the housing 12.

The inside of the housing 12 is maintained at normal temperature. Therefore, the substrate W is treated under an environment of the normal temperature. Here, the normal temperature includes a room temperature. The normal temperature is, for example, a temperature in a range of 5°C or more and 35°C or less. The normal temperature is, for example, a temperature in a range of 10°C or more and 30°C or less. The normal temperature is, for example, a temperature in a range of 20°C or more and 25°C or less.

The inside of the housing 12 is maintained at normal pressure. Therefore, the substrate W is treated under an environment of the normal pressure. Here, the normal pressure includes normal atmospheric pressure (1 atm, 101325 Pa). The normal pressure is, for example, an atmospheric pressure in a range of 0.7 atm or more and 1.3 atm or less. In the present description, the pressure values are given in absolute pressure with reference to absolute vacuum.

The substrate holder 13 is installed inside the housing 12. The substrate holder 13 holds one substrate W. The substrate holder 13 holds the substrate W in a substantially horizontal posture.

The substrate holder 13 is located below the substrate W held by the substrate holder 13. The substrate holder 13 is in contact with at least one of a lower surface of the substrate W and the peripheral edge of the substrate W. The lower surface of the substrate W is also referred to as backside of the substrate W. The substrate holder 13 is not in contact with an upper surface of the substrate W.

The treating unit 11 includes a rotation driving unit 14. At least a part of the rotation driving unit 14 is installed inside the housing 12. The rotation driving unit 14 is connected to the substrate holder 13. The rotation driving unit 14 rotates the substrate holder 13. The substrate W held by the substrate holder 13 rotates integrally with the substrate holder 13. The substrate W held by the substrate holder 13 rotates about a rotation axis B. The rotation axis B passes through the center of the substrate W and extends in the vertical direction Z, for example.

The treating unit 11 includes a supplying unit 15. The supplying unit 15 supplies a liquid or a gas to the substrate W held by the substrate holder 13. Specifically, the supplying unit 15 supplies a liquid or a gas to the upper surface of the substrate W held by the substrate holder 13.

The supplying unit 15 includes a first supplying unit 15a, a second supplying unit 15b, a third supplying unit 15c, a fourth supplying unit 15d, a fifth supplying unit 15e, and a sixth supplying unit 15f. The first supplying unit 15a supplies a drying auxiliary liquid g. The second supplying unit 15b supplies an etching liquid. The third supplying unit 15c supplies a hydrophilic agent. The fourth supplying unit 15d supplies a rinse liquid. The fifth supplying unit 15e supplies a replacement liquid. The sixth supplying unit 15f supplies a dry gas.

The liquid and the gas supplied by the supplying unit 15 will be described.

The drying auxiliary liquid g supplied by the first supplying unit 15a is used for drying the substrate W. The drying auxiliary liquid g has a function of assisting the drying of the substrate W.

The drying auxiliary liquid g contains a sublimable substance. The sublimable substance has a sublimation property. The term "sublimation property" refers to a property of a single substance, a compound, or a mixture that undergoes a phase transition from a solid to a gas or from a gas to a solid without being transitioned to a liquid.

The sublimable substance contains an organic compound containing an oxime group. The oxime group is also referred to as "C=N-OH group". The organic compounds containing the oxime group are also referred to as oximes.

The sublimable substance contains, for example, cyclohexanone oxime. Cyclohexanone oxime is represented by the following chemical formula (1). As shown in chemical formula (1), cyclohexanone oxime is an example of an organic compound containing the oxime group.

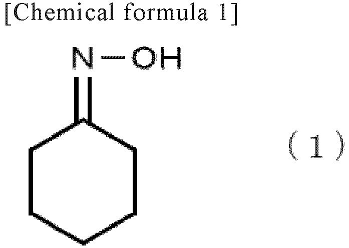

The sublimable substance contains, for example, pinacolinoxime. The sublimable substance contains, for example, at least one of cyclohexanone oxime and pinacoline oxime. Pinacolinoxime is also an example of an organic compound containing the oxime group.

The sublimable substance does not contain a fluorocarbon compound. Cyclohexanone oxime is not a fluorocarbon compound. Pinacolinoxime is also not a fluorocarbon compound.

The drying auxiliary liquid g contains a first solvent. The first solvent has solubility with respect to the sublimable substance. The sublimable substance in the drying auxiliary liquid g is dissolved in the first solvent. That is, the drying auxiliary liquid g contains the first solvent and the sublimable substance dissolved in the first solvent. The sublimable substance corresponds to a solute of the drying auxiliary liquid g.

For example, it is preferable that the vapor pressure of the first solvent is higher than the vapor pressure of the sublimable substance. For example, it is preferable that the vapor pressure of the first solvent at normal temperature is higher than the vapor pressure of the sublimable substance at normal temperature.

The first solvent is, for example, an organic solvent. The first solvent is, for example, alcohol. The first solvent is, for example, isopropyl alcohol (IPA). Hereinafter, isopropyl alcohol is referred to as "IPA".

It is preferable that the drying auxiliary liquid g does not contain water. The drying auxiliary liquid g is composed of, for example, only the sublimable substance and the first solvent. The drying auxiliary liquid g is composed of, for example, only cyclohexanone oxime and IPA. The drying auxiliary liquid g is composed of, for example, only pinacolinoxime and IPA.

The drying auxiliary liquid g is, for example, a mixed liquid of the sublimable substance and the first solvent. The drying auxiliary liquid g is obtained by, for example, mixing the sublimable substance and the first solvent.

It is preferable that an initial amount Qb of the first solvent in the drying auxiliary liquid g is larger than an initial amount Qa of the sublimable substance in the drying auxiliary liquid g. The initial amount Qa corresponds to, for example, the amount of the sublimable substance used to generate the drying auxiliary liquid g. The initial amount Qb corresponds to the amount of the first solvent used to generate the drying auxiliary liquid g. The units of the initial amounts Qa and Qb are respectively, for example, in volume. The ratio of the initial amount Qa to the initial amount Qb is referred to as "mixing ratio R".

The etching liquid supplied by the second supplying unit 15b contains, for example, at least one of hydrofluoric acid (HF) and buffered hydrofluoric acid (BHF).

The hydrophilic agent supplied by the third supplying unit 15c forms a hydroxy group on the surface WS. The hydroxy group is also referred to as "-OH group".

The hydrophilic agent is, for example, an ammonia hydrogen peroxide mixture. Hereinafter, the ammonia hydrogen peroxide mixture is referred to as "APM" as appropriate. APM is a liquid. APM is also referred to as "SC-1".

The third supplying unit 15c is an example of a hydrophilization unit of the present invention.

The rinse liquid supplied by the fourth supplying unit 15d contains water. The rinse liquid is, for example, deionized water (DIW). The rinse liquid is composed of, for example, only deionized water (DIW).

The replacement liquid supplied by the fifth supplying unit 15e has solubility with respect to the rinse liquid and the drying auxiliary liquid g. The replacement liquid is compatible with the rinse liquid and the drying auxiliary liquid g.

The replacement liquid contains, for example, an organic solvent. The replacement liquid contains, for example, IPA.

It is preferable that the replacement liquid does not contain water. The replacement liquid is composed of, for example, only an organic solvent. The replacement liquid is composed of, for example, only IPA.

It is preferable that the dry gas supplied by the sixth supplying unit 15f has a dew point lower than normal temperature. The dry gas is, for example, at least one of an air and an inert gas. The air is, for example, compressed air. The inert gas is, for example, nitrogen gas.

The configuration of the supplying unit 15 will be described.

The first supplying unit 15a includes a nozzle 16a. Similarly, the second to sixth supplying units 15b to 15f include nozzles 16b to 16f, respectively. The nozzles 16a to 16f are installed inside the housing 12, respectively. The nozzle 16a dispenses the drying auxiliary liquid g. The nozzle 16b dispenses the etching liquid. The nozzle 16c dispenses the hydrophilic agent. The nozzle 16d dispenses the rinse liquid. The nozzle 16e dispenses the replacement liquid. The nozzle 16f dispenses the dry gas.

The first supplying unit 15a includes a pipe 17a and a valve 18a. The pipe 17a is connected to the nozzle 16a. The valve 18a is provided on the pipe 17a. When the valve 18a is opened, the nozzle 16a dispenses the drying auxiliary liquid g. When the valve 18a is closed, the nozzle 16a does not dispense the drying auxiliary liquid g. Similarly, the second to sixth supplying units 15b to 15f include pipes 17b to 17f and valves 18b to 18f, respectively. The pipes 17b to 17f are connected to the nozzles 16b to 16f, respectively. The valves 18b to 18f are provided on the pipes 17b to 17f, respectively. The valves 18b to 18f control dispense of the etching liquid, the hydrophilic agent, the rinse liquid, the replacement liquid, and the dry gas, respectively.

At least a part of the pipe 17a may be provided outside the housing 12. The pipes 17b to 17f may be disposed in the same manner as the pipe 17a. The valve 18a may be provided outside the housing 12. The valves 18b to 18f may be disposed in the same manner as the valve 18a.

The substrate treating apparatus 1 includes a first supplying source 19a. The first supplying source 19a communicates with the first supplying unit 15a. The first supplying source 19a is connected to the first supplying unit 15a. The first supplying source 19a is connected to, for example, the pipe 17a. The first supplying source 19a is provided outside the housing 12. The first supplying source 19a sends the drying auxiliary liquid g to the first supplying unit 15a. Similarly, the second to sixth supplying units 15b to 15f communicate with the second to sixth supplying sources 19b to 19f, respectively. The second to sixth supplying units 15b to 15f are connected to the second to sixth supplying sources 19b to 19f, respectively. The second to sixth supplying sources 19b to 19f are connected to, for example, the pipes 17b to 17f, respectively. The second to sixth supplying sources 19b to 19f are provided outside the housing 12, respectively. The second supplying source 19b supplies the etching liquid to the second supplying unit 15b. The third supplying source 19c supplies the hydrophilic agent to the third supplying unit 15c. The fourth supplying source 19d supplies the rinse liquid to the third supplying unit 15c. The fifth supplying source 19e supplies the replacement liquid to the fourth supplying unit 15d. The sixth supplying source 19f supplies the dry gas to the fifth supplying unit 15e.

The first supplying source 19a may supply the drying auxiliary liquid g to the plurality of treating units 11. Alternatively, the first supplying source 19a may supply the drying auxiliary liquid g to only one treating unit 11. The same applies to the second to sixth supplying sources 19b to 19f.

The second supplying source 19b may be a component of the substrate treating apparatus 1. For example, the second supplying source 19b may be a storage tank included in the substrate treating apparatus 1. Alternatively, the second supplying source 19b may not be a component of the substrate treating apparatus 1. For example, the second supplying source 19b may be a utility facility installed outside the substrate treating apparatus 1. Similarly, the third to sixth supplying sources 19c to 19f may be components of the substrate treating apparatus 1, respectively. Alternatively, the third to sixth supplying sources 19c to 19f may not be components of the substrate treating apparatus 1, respectively.

The treating unit 11 may further include a cup which is not shown. The cup is installed inside the housing 12. The cup is disposed around the substrate holder 13. The cup receives the liquid scattered from the substrate W held by the substrate holder 13.

Reference is made to FIG. 3. The controller 10 controls the rotation driving unit 14. The controller 10 controls the supplying unit 15. The controller 10 controls the first to sixth supplying units 15a to 15f. The controller 10 controls the valves 18a to 18f.

### <1-4. Configuration of first supplying source 19a>

Reference is made to FIG. 4. The first supplying source 19a further generates the drying auxiliary liquid g. A configuration example of the first supplying source 19a is illustrated.

The first supplying source 19a includes a generating unit 21 and a pressure feed unit 31. The generating unit 21 generates the drying auxiliary liquid g. The pressure feed unit 31 sends the drying auxiliary liquid g to the first supplying unit 15a.

The generating unit 21 includes a tank 22 and supplying units 23a and 23b. The supplying unit 23a supplies the sublimable substance to the tank 22. The supplying unit 23b supplies the first solvent to the tank 22. The sublimable substance and the first solvent are mixed in the tank 22. The sublimable substance and the first solvent become the drying auxiliary liquid g in the tank 22.

The tank 22 is installed under an environment of normal temperature. The tank 22 is installed under an environment of normal pressure. Therefore, the drying auxiliary liquid g is generated under the environment of normal temperature. The drying auxiliary liquid g is generated under the environment of normal pressure.

Further, the generating unit 21 stores the drying auxiliary liquid g. Specifically, the drying auxiliary liquid g is stored in the tank 22. The drying auxiliary liquid g is stored under an environment of normal temperature. The drying auxiliary liquid g is stored under an environment of normal pressure.

The supplying unit 23a includes, for example, a pipe 24a and a valve 25a. The pipe 24a communicates with the tank 22. The pipe 24a is connected to the tank 22. The valve 25a is provided on the pipe 24a. When the valve 25a is opened, the supplying unit 23a supplies the tank 22 with the sublimable substance. When the valve 25a is closed, the supplying unit 23a does not supply the tank 22 with the sublimable substance. Similarly, the supplying unit 23b includes a pipe 24b and a valve 25b. The pipe 24b communicates with the tank 22. The pipe 24b is connected to the tank 22. The valve 25b is provided on the pipe 24b. The valve 25b controls the supply of the first solvent to the tank 22.

The valve 25a adjusts the amount of the sublimable substance supplied to the tank 22. The valve 25b adjusts the amount of the first solvent supplied to the tank 22. The amount of the sublimable substance supplied to the tank 22 corresponds to the initial amount Qa. The amount of the first solvent supplied to the tank 22 corresponds to the initial amount Qb. Therefore, the valves 25a and 25b adjust the mixing ratio R of the drying auxiliary liquid g.

The valves 25a and 25b may each include a flow rate regulating valve, for example. The valves 25a and 25b may include, for example, a flow rate regulating valve and an on-off valve, respectively.

The supplying unit 23a communicates with a supplying source 26a. The supplying unit 23a is connected to the supplying source 26a. For example, the supplying source 26a is connected to the pipe 24a. The supplying source 26a sends the sublimable substance to the supplying unit 23a. Similarly, the supplying unit 23b communicates with a supplying source 26b. The supplying unit 23b is connected to the supplying source 26b. For example, the supplying source 26b is connected to the pipe 24b. The supplying source 26b delivers the first solvent to the supplying unit 23b. The supplying sources 26a and 26b may be components of the substrate treating apparatus 1, respectively. Alternatively, the supplying sources 26a and 26b may not be components of the substrate treating apparatus 1, respectively.

The pressure feed unit 31 communicates with the generating unit 21. Specifically, the pressure feed unit 31 includes a pipe 32 and a joint 33. The pipe 32 communicates with the tank 22. The pipe 32 is connected to the tank 22. The joint 33 is connected to the pipe 32.

The pressure feed unit 31 further communicates with the first supplying unit 15a. Specifically, the joint 33 communicates with the first supplying unit 15a. The joint 33 is connected to, for example, the pipe 17a.

The tank 22 is connected to the first supplying unit 15a via the pipe 32 and the joint 33. The tank 22 communicates with the first supplying unit 15a. The tank 22 communicates with the nozzle 16a.

The pressure feed unit 31 further includes a pump 34 and a filter 35. The pump 34 is provided on the pipe 32. When the pump 34 operates, the pump 34 sends the drying auxiliary liquid g from the tank 22 to the first supplying unit 15a. When the pump 34 operates, the pump 34 pumps the drying auxiliary liquid g from the tank 22 to the first supplying unit 15a. When the pump 34 stops operating, the pump 34 does not send the drying auxiliary liquid g from the tank 22 to the first supplying unit 15a. When the pump 34 stops operating, the pump 34 does not pump the drying auxiliary liquid g from the tank 22 to the first supplying unit 15a. The filter 35 is provided in the pipe 32. The drying auxiliary liquid g passes through the filter 35. The filter 35 filters the drying auxiliary liquid g. The filter 35 removes foreign matters from the drying auxiliary liquid g.

Reference is made to FIG. 3. The controller 10 can communicate with the first supplying source 19a. The controller 10 controls the first supplying source 19a. The controller 10 controls the generating unit 21. The controller 10 controls the supplying units 23a and 23b. The controller 10 controls the valves 25a and 25b. The controller 10 controls the pressure feed unit 31. The controller 10 controls the pump 34.

The controller 10 has generation condition information for controlling the generating unit 21. The generation condition information includes, for example, targets for the initial amounts Qa and Qb. The generation condition information includes, for example, a target for the mixing ratio R. The generation condition information is stored in advance in the storage medium of the controller 10.

### <1-5. Operation example of first supplying source 19a and treating unit 11>

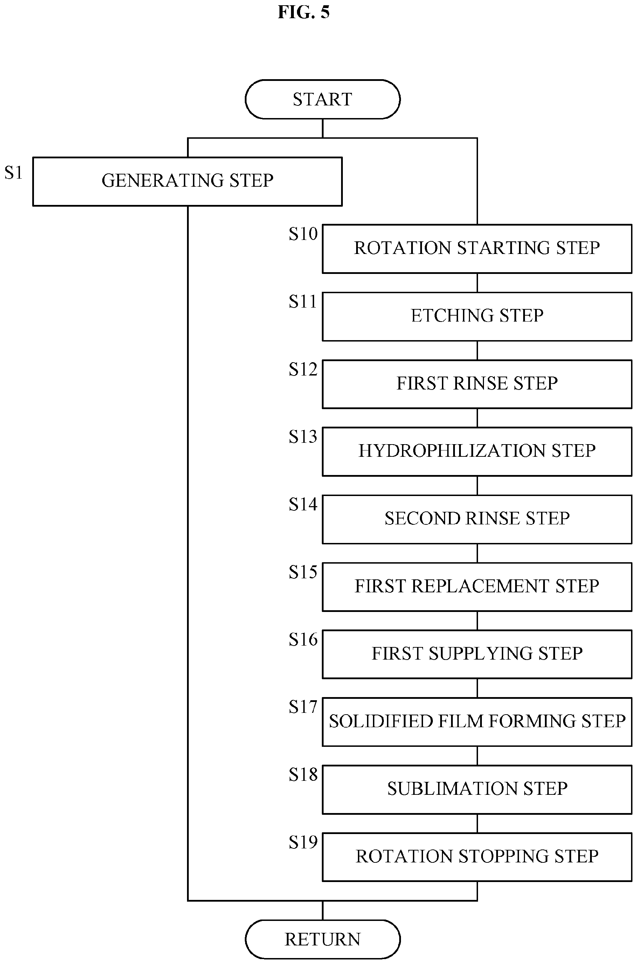

FIG. 5 is a flowchart showing a procedure of the substrate treating method of the first embodiment. The substrate treating method is for treating the substrate W. As described above, the substrate W has the pattern WP formed on the surface WS. The substrate treating method includes Step S1 and Steps S10 to S19. Steps S10 to S19 are executed in parallel with Step S1. Steps S10 to S19 are executed in this order.

Step S1 is executed by the first supplying source 19a. Steps S10 to S19 are substantially executed by the treating unit 11. The first supplying source 19a and the treating unit 11 operate under the control of the controller 10.

Steps S1 and S10 to S19 will be described with reference to FIG. 4 as appropriate.

### Step S1: Generating step

In a generating step, the drying auxiliary liquid g is generated.

The controller 10 controls the generating unit 21 based on the generation condition information. The generating unit 21 generates the drying auxiliary liquid g. For example, the controller 10 controls the supplying units 23a and 23b based on the targets for the initial amounts Qa and Qb. For example, the controller 10 controls the supplying units 23a and 23b based on the target for the mixing ratio R. The supplying unit 23a supplies the sublimable substance to the tank 22. The supplying unit 23b supplies the first solvent to the tank 22. The drying auxiliary liquid g is generated in the tank 22. The drying auxiliary liquid g is stored in the tank 22.

### Step S10: Rotation starting step

The substrate holder 13 holds the substrate W. The substrate W is held in a substantially horizontal posture.

When the substrate W is held by the substrate holder 13, the first surface WS1 of the substrate W faces upward. When the substrate W is held by the substrate holder 13, the first surface WS1 of the substrate W is located on the upper surface of the substrate W. When the substrate W is held by the substrate holder 13, the pattern WP faces upward. When the substrate W is held by the substrate holder 13, the pattern WP is located on the upper surface of the substrate W.

The rotation driving unit 14 rotates the substrate holder 13. Thus, the substrate W held by the substrate holder 13 starts rotating.

In Steps S11 to S18 to be described later, the substrate W keeps rotating, for example.

### Step S11: Etching step

In an etching step, an etching liquid is supplied to the substrate W. In the etching step, an oxide film on the substrate W is removed.

The second supplying unit 15b supplies the etching liquid to the substrate W held by the substrate holder 13. Specifically, the valve 18b opens. The nozzle 16b dispenses the etching liquid. The etching liquid is supplied to the surface WS (specifically, the first surface WS1). The etching liquid is in contact with the surface WS (specifically, the first surface WS1). That is, the etching liquid is in contact with the pattern WP.

In the following description, the surface WS specifically means the first surface WS1. That is, in the following description, the "surface WS" is synonymous with the "surface WS (specifically, the first surface WS1)".

The etching liquid etches the substrate W. The etching liquid etches the oxide film on the substrate W. The etching liquid etches the oxide film on the surface WS. The oxide film on the substrate W is removed. The oxide film on the substrate W is removed from the substrate W.

Thereafter, the second supplying unit 15b stops supplying the etching liquid to the substrate W. Specifically, the valve 18b is closed. The nozzle 16b stops dispensing the etching liquid.

### Step S12: First rinse step

After the etching step, a first rinse step is executed. In the first rinse step, a rinse liquid is supplied to the substrate W. In the present description, the rinse liquid supplied to the substrate W in the first rinse step is referred to as "first rinse liquid".

The fourth supplying unit 15d supplies the first rinse liquid to the substrate W held by the substrate holder 13. Specifically, the valve 18d opens. The nozzle 16d dispenses the first rinse liquid. The first rinse liquid is supplied to the surface WS.

The first rinse liquid cleans the substrate W. Specifically, the first rinse liquid removes the etching liquid on the substrate W. The etching liquid on the substrate W is removed from the substrate W. The etching liquid on the substrate W is replaced with the first rinse liquid. The first rinse liquid is in contact with the surface WS.

Thereafter, the fourth supplying unit 15d stops supplying the first rinse liquid to the substrate W. Specifically, the valve 18d is closed. The nozzle 16d stops dispensing the first rinse liquid.

### Step S13: Hydrophilization step

After the first rinse step, a hydrophilization step is executed. In the hydrophilization step, a hydrophilic agent is supplied to the substrate W. In the hydrophilization step, for example, APM is supplied to the substrate W. In the hydrophilization step, the hydroxy group is formed on the surface WS.

The third supplying unit 15c supplies the hydrophilic agent to the substrate W held by the substrate holder 13. Specifically, the valve 18c opens. The nozzle 16c dispenses the hydrophilic agent. The hydrophilic agent is supplied to the surface WS.

The hydrophilic agent removes the first rinse liquid on the substrate W. The first rinse liquid on the substrate W is removed from the substrate W. The first rinse liquid on the substrate W is replaced with the hydrophilic agent. The hydrophilic agent is in contact with the surface WS.

The hydrophilic agent forms the hydroxy group on the surface WS. Specifically, the hydroxy group terminates the surface WS of the substrate W. The hydroxy group terminates an atom located on the surface WS of the substrate W. The hydroxy group is bonded to the atom located on the surface WS of the substrate W. The hydroxy group is bonded to a bonding hand of the atom located on the surface WS of the substrate W. The atom is, for example, a silicon atom. Hydroxy groups and silicon atoms which are bonded to one another are also referred to as silanol groups. The bonding hand is, for example, a dangling bond.

When the hydrophilic agent is APM, APM forms an oxide film on the surface WS and forms the hydroxy group on the oxide film.

The formation of the hydroxy group on the surface WS makes the surface WS hydrophilic.

As described above, the third supplying unit 15c forms the hydroxy group on the surface WS of the substrate W held by the substrate holder 13.

Thereafter, the third supplying unit 15c stops supplying the hydrophilic agent to the substrate W. Specifically, the valve 18c is closed. The nozzle 16c stops dispensing the hydrophilic agent.

### Step S14: Second rinse step

After the hydrophilization step, a second rinse step is executed. In the second rinse step, the rinse liquid is supplied to the substrate W. In the second rinse step, the rinse liquid is supplied to the substrate W having the hydroxy group. In the present description, the rinse liquid supplied to the substrate W in the second rinse step is referred to as "second rinse liquid".

In the first embodiment, the second rinse liquid is the same type as the first rinse liquid. The composition of the second rinse liquid is, for example, the same as the composition of the first rinse liquid. For example, both the first rinse liquid and the second rinse liquid are deionized water.

The fourth supplying unit 15d supplies the second rinse liquid to the substrate W held by the substrate holder 13. Specifically, the valve 18d opens. The nozzle 16d dispenses the second rinse liquid. The second rinse liquid is supplied to the surface WS.

The second rinse liquid cleans the substrate W. Specifically, the second rinse liquid removes the hydrophilic agent on the substrate W. The hydrophilic agent on the substrate W is removed from the substrate W. The hydrophilic agent on the substrate W is replaced with the second rinse liquid. The second rinse liquid is in contact with the surface WS.

The hydroxy group formed on the surface WS of the substrate W is not removed by the second rinse liquid. After the second rinse replacement step, the substrate W also has the hydroxy group formed on the surface WS.

Thereafter, the fourth supplying unit 15d stops supplying the second rinse liquid to the substrate W. Specifically, the valve 18d is closed. The nozzle 16d stops dispensing the second rinse liquid.

### Step S15: First replacement step

After the second rinse step, a first replacement step is executed. In the first replacement step, the replacement liquid is supplied to the substrate W. In the first replacement step, the replacement liquid is supplied to the substrate W having the hydroxy group. In the present description, the replacement liquid supplied to the substrate W in the first replacement step is referred to as "first replacement liquid".

The fifth supplying unit 15e supplies the first replacement liquid to the substrate W held by the substrate holder 13. Specifically, the valve 18e opens. The nozzle 16e dispenses the first replacement liquid. The first replacement liquid is supplied to the surface WS.

The first replacement liquid removes the second rinse liquid on the substrate W. The second rinse liquid on the substrate W is removed from the substrate W. The second rinse liquid on the substrate W is replaced with the first replacement liquid. The first replacement liquid is in contact with the surface WS.

The hydroxy group formed on the surface of the substrate W is not removed by the first replacement liquid. After the first replacement step, the substrate W also has the hydroxy group formed on the surface WS.

Thereafter, the fifth supplying unit 15e stops supplying the first replacement liquid to the substrate W. Specifically, the valve 18e is closed. The nozzle 16e stops dispensing the first replacement liquid.

### Step S16: First supplying step

After the first replacement step, a first supplying step is executed. In the first supplying step, the drying auxiliary liquid g is supplied to the substrate W. The drying auxiliary liquid g contains the sublimable substance and the first solvent. In the first supplying step, the drying auxiliary liquid g is supplied to the substrate W having the hydroxy group. The hydroxy group is located on the surface WS.

The pressure feed unit 31 supplies the drying auxiliary liquid g to the first supplying unit 15a. The first supplying unit 15a supplies the drying auxiliary liquid g to the substrate W held by the substrate holder 13. Specifically, the pump 34 sends the drying auxiliary liquid g from the tank 22 to the first supplying unit 15a. The pump 34 pumps the drying auxiliary liquid g from the tank 22 to the first supplying unit 15a. The valve 18a opens. The nozzle 16a dispenses the drying auxiliary liquid g. The drying auxiliary liquid g is supplied to the surface WS.

The drying auxiliary liquid g removes the first replacement liquid on the substrate W. The first replacement liquid on the substrate W is removed from the substrate W. The first replacement liquid on the substrate W is replaced with the drying auxiliary liquid g. The drying auxiliary liquid g is in contact with the surface WS.

Thereafter, the pressure feed unit 31 stops supplying the drying auxiliary liquid g to the first supplying unit 15a. The first supplying unit 15a stops supplying the drying auxiliary liquid g to the substrate W. Specifically, the pump 34 is stopped. The valve 18a is closed. The nozzle 16a stops dispensing the drying auxiliary liquid g.

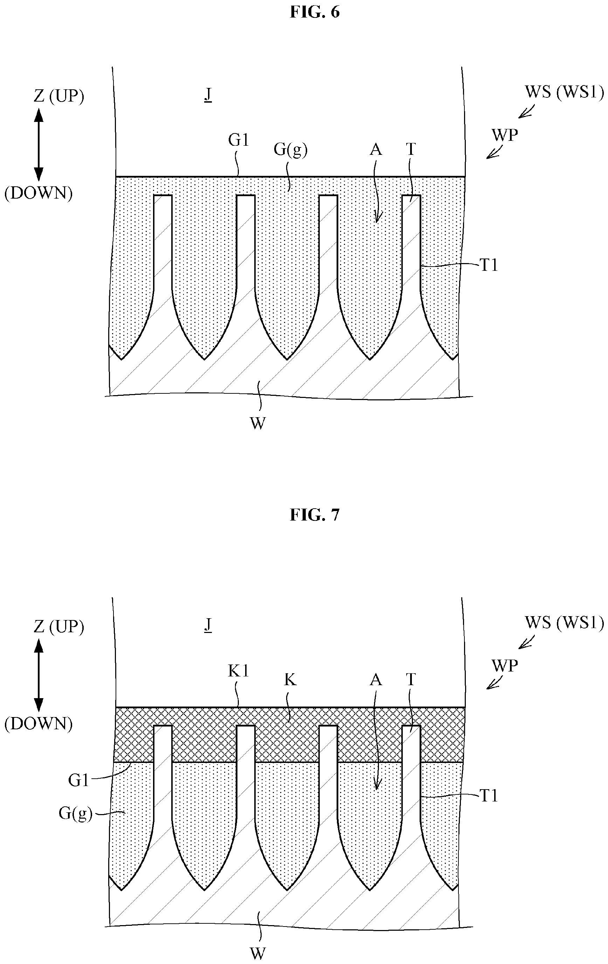

FIG. 6 is a view schematically showing the substrate W in the first supplying step. The drying auxiliary liquid g on the substrate W forms a liquid film G. The liquid film G is located on the substrate W. The liquid film G is in contact with the substrate W.

Specifically, the liquid film G is located on the surface WS. The liquid film G is in contact with the surface WS. The liquid film G covers the surface WS. That is, the liquid film G is in contact with the pattern WP. The liquid film G covers the pattern WP.

The entire pattern WP is immersed in the liquid film G. The entire projection T is immersed in the liquid film G. The recess A is filled with the liquid film G. The entire recess A is filled with only the liquid film G.

The liquid film G has an upper surface G1. The upper surface G1 is located at a position higher than the entire pattern WP. The upper surface G1 does not intersect with the pattern WP. The upper surface G1 is located at a position higher than the entire projection T. The upper surface G1 does not intersect with the projection T.

The first replacement liquid has already been removed from the substrate W by the drying auxiliary liquid g. Therefore, in FIG. 6, the first replacement liquid is not present on the substrate W. In FIG. 6, the first replacement liquid is not present in the recess A.

A gas J is present above the liquid film G. The pattern WP is not in contact with the gas J. The pattern WP is not exposed to the gas J. The projection T is not in contact with the gas J. The projection T is not exposed to the gas J.

The gas J is in contact with the liquid film G. The gas J is in contact with the upper surface G1. The upper surface G1 corresponds to a gas-liquid interface between the liquid film G and the gas J. Therefore, the pattern WP does not intersect with the gas-liquid interface between the liquid film G and the gas J. The projection T does not intersect with the gas-liquid interface between the liquid film G and the gas J. Therefore, the liquid film G does not apply a significant force to the pattern WP. The liquid film G does not apply a significant force to the projection T.

In the first supplying step, the height position of the upper surface G1 may be further adjusted. For example, the height position of the upper surface G1 may be adjusted while the first supplying unit 15a supplies the drying auxiliary liquid g to the substrate W. For example, the height position of the upper surface G1 may be adjusted after the first supplying unit 15a stops supplying the drying auxiliary liquid g. For example, the height position of the upper surface G1 may be adjusted by adjusting the rotation speed of the substrate W. For example, the height position of the upper surface G1 may be adjusted by adjusting the rotation time of the substrate W.

### Step S17: Solidified film forming step

After the first supplying step, a solidified film forming step is executed. In the solidified film forming step, the first solvent evaporates from the drying auxiliary liquid g on the substrate W. In the solidified film forming step, a solidified film is formed on the substrate W. The solidified film contains the sublimable substance.

FIG. 7 is a view schematically showing the substrate W in the solidified film forming step. As described above, the first solvent has a relatively high vapor pressure. Specifically, the first solvent has a vapor pressure higher than that of the sublimable substance at normal temperature. Therefore, the first solvent smoothly evaporates from the drying auxiliary liquid g on the substrate W. The first solvent smoothly changes from a liquid into a gas.

Due to the evaporation of the first solvent from the drying auxiliary liquid g on the substrate W, the first solvent leaves the drying auxiliary liquid g on the substrate W. The evaporation of the first solvent from the drying auxiliary liquid g on the substrate W decreases the amount of the first solvent contained in the liquid film G. As the amount of the first solvent contained in the liquid film G decreases, the concentration of the sublimable substance in the liquid film G increases.

The sublimable substance in the liquid film G then starts to precipitate on the substrate W. That is, the sublimable substance changes from the solute of the drying auxiliary liquid g to a solid-phase sublimable substance. The solid-phase sublimable substance forms the solidified film K. The solidified film K does not contain the first solvent. The solidified film K is solid. The solidified film K is formed on the substrate W. The solidified film K is located on the substrate W. Specifically, the solidified film K is formed on the surface WS. The solidified film K is located on the surface WS.

The liquid film G gradually decreases due to the evaporation of the first solvent and the precipitation of the sublimable substance. The liquid film G is gradually changed into the solidified film K by the precipitation of the sublimable substance.

First, the upper portion of the liquid film G is changed into the solidified film K. The solidified film K is located at the upper portion of the liquid film G. The solidified film K covers the upper surface G1 of the liquid film G.

When the solidified film K covers the entire upper surface G1, the solidified film K separates the liquid film G from the gas J. The liquid film G is in contact with the solidified film K. The upper surface G1 of the liquid film G is in contact with the solidified film K. The liquid film G is not in contact with the gas J. The upper surface G1 is not in contact with the gas J. The gas-liquid interface between the liquid film G and the gas J disappears.

Therefore, the pattern WP does not intersect with the gas-liquid interface. The projection T does not intersect with the gas-liquid interface. Therefore, the liquid film G does not apply a significant force to the pattern WP. The liquid film G does not apply a significant force to the projection T.

The solidified film K is in contact with the gas J. The solidified film K has an upper surface K1. The upper surface K1 is in contact with the gas J.

The liquid film G further decreases. The liquid film G decreases without the liquid film G applying a significant force to the projection T. The first solvent leaves the substrate W without applying a significant force to the projection T. The height position of the upper surface G1 is further lowered. The solidified film K further increases.

The solidified film K may be generated before the first supplying step ends. A part of the period in which the solidified film forming step is executed may overlap a part of the period in which the first supplying step is executed.

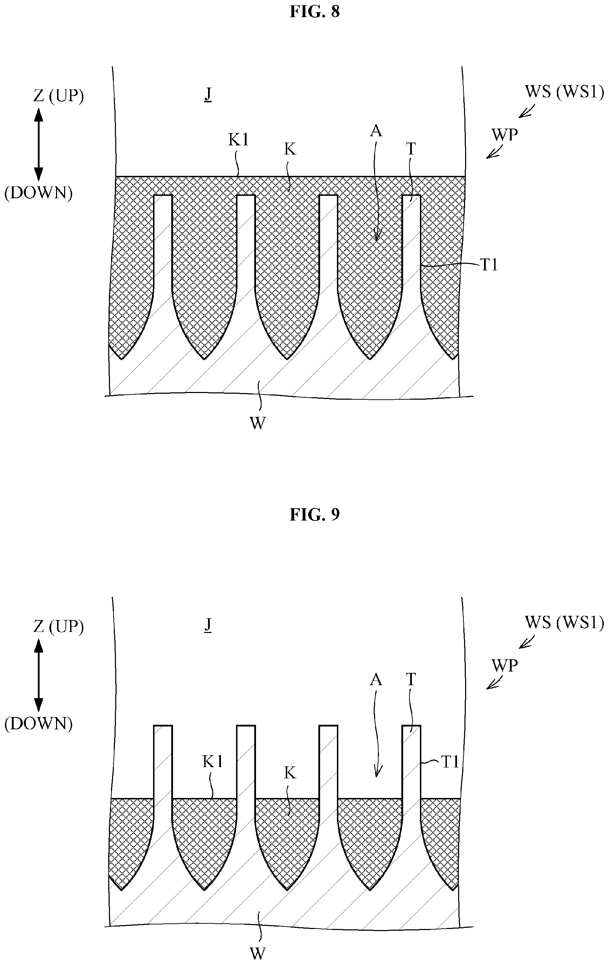

FIG. 8 is a view schematically showing the substrate W in the solidified film forming step. FIG. 8 schematically shows the substrate W at the end of the solidified film forming step, for example. Only the solidified film K is present on the substrate W. At the end of the solidified film forming step, the liquid film G disappears entirely from the substrate W. The liquid film G does not remain in the recess A. All of the first solvent disappears from the substrate W. The first solvent also does not remain in the recess A.

The surface WS is in contact with the solidified film K. The pattern WP is in contact with the solidified film K. The projection T is in contact with the solidified film K. The side T1 of the projection T is in contact with the solidified film K. The recess A is filled with the solidified film K. The entire recess A is filled with only the solidified film K.

The solidified film K supports the pattern WP. The solidified film K protects the pattern WP. For example, the solidified film K prevents the pattern WP from collapsing.

The solidified film K supports the projection T. The solidified film K protects the projection T. For example, the solidified film K prevents the projection T from collapsing. For example, the solidified film K prevents the projection T from being inclined. For example, the solidified film K prevents two adjacent projections T from coming into contact with each other.

### Step S18: Sublimation step

After the solidified film forming step, a sublimation step is executed. In the sublimation step, the solidified film K is sublimated.

The sixth supplying unit 15f supplies the dry gas to the substrate W held by the substrate holder 13. Specifically, the valve 18f opens. The nozzle 16f dispenses the dry gas. The nozzle 16f blows out the dry gas. The dry gas is supplied to the surface WS. The dry gas is supplied to the solidified film K. The solidified film K is exposed to the dry gas. Thus, the solidified film K is sublimated. The solidified film K changes into a gas without being transitioned to a liquid. The solidified film K is removed from the substrate W by the sublimation of the solidified film K.

Thereafter, the sixth supplying unit 15f stops supplying the dry gas to the solidified film K. Specifically, the valve 18f is closed. The nozzle 16f stops blowing out the dry gas.

FIG. 9 is a view schematically showing the substrate W in the sublimation step. As the solidified film K is sublimated, the solidified film K gradually decreases. As the solidified film K is sublimated, the solidified film K gradually becomes thinner. As the solidified film K is sublimated, the height position of the upper surface K1 is gradually lowered.

Note that the sublimable substance has the sublimation property. Therefore, the sublimation of the solidified film K may start before the liquid film G disappears from the substrate W. A part of the period in which the sublimation step is executed may overlap a part of the period in which the solidified film forming step is executed.

The pattern WP starts to be exposed to the gas J. The projection T starts to be exposed to the gas J.

When the solidified film K is sublimated, the solidified film K is not changed into a liquid. The solidified film K does not apply a significant force to the pattern WP. The solidified film K does not apply a significant force to the projection T. The solidified film K leaves the substrate W without applying a significant force to the pattern WP. The solidified film K leaves the substrate W without applying a significant force to the projection T.

In the sublimation step, no liquid is present on the substrate W. In the sublimation step, no liquid is present on the surface WS. In the sublimation step, no liquid is present on the pattern WP. In the sublimation step, no liquid is present in the recess A. Therefore, in the sublimation step, a gas-liquid interface intersecting with the pattern WP is not generated. In the sublimation step, a gas-liquid interface intersecting the projection T is not generated. Therefore, in the sublimation step, the pattern WP is not subjected to surface tension. In the sublimation step, the projection T is not subjected to surface tension.

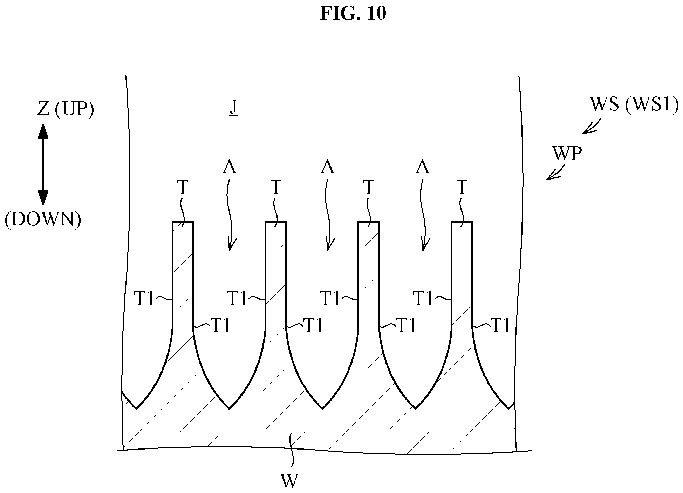

FIG. 10 is a view schematically showing the substrate W in the sublimation step. FIG. 10 schematically shows the substrate W at the end of the sublimation step, for example. At the end of the sublimation step, the entire solidified film K disappears from the substrate W. No liquid is present on the substrate W. The surface WS is exposed to the gas J. The entire pattern WP is exposed to the gas J. The entire projection T is exposed to the gas J. The entire recess A is filled with only the gas J. The substrate W is dried.

The treatments in the first supplying step, the solidified film forming step, and the sublimation step described above are examples of the drying treatment. The treatments in the first supplying step, the solidified film forming step, and the sublimation step described above correspond to use examples of the drying auxiliary liquid g. The drying auxiliary liquid g is used under an environment of normal temperature. The drying auxiliary liquid g is used under an environment of normal pressure.

### Step S19: Rotation stopping step

The rotation driving unit 14 stops rotating the substrate holder 13. The substrate W held by the substrate holder 13 stops rotating. The substrate W rests. The treating unit 11 ends the treatment on the substrate W.

### <1-6. Technical significance of hydrophilization step>

The technical significance of the hydrophilization step will be described by Example 1 and Comparative Example 1. In Example 1, the substrate W is treated by a substrate treating method including the hydrophilization step. In Comparative Example 1, the substrate W is treated by a substrate treating method that does not include the hydrophilization step.

The conditions of Example 1 will be described. In Example 1, the substrate W is treated in the etching step, the first rinse step, the hydrophilization step, the second rinse step, the first replacement step, the first supplying step, the solidified film forming step, and the sublimation step. The etching liquid is hydrofluoric acid (HF). The first rinse liquid is deionized water (DIW). The hydrophilic agent is APM. The second rinse liquid is deionized water (DIW). The first replacement liquid is IPA. The sublimable substance of the drying auxiliary liquid g is cyclohexanone oxime. The first solvent of the drying auxiliary liquid g is IPA.

The conditions of Comparative Example 1 will be described. In Comparative Example 1, the substrate W is treated in the etching step, the first rinse step, the first replacement step, the first supplying step, the solidified film forming step, and the sublimation step. In Comparative Example 1, the substrate W is not treated in the hydrophilization step and the second rinse step. Therefore, in Comparative Example 1, the hydrophilic agent and the second rinse liquid are not supplied to the substrate W. The conditions of Comparative Example 1 are the same as the conditions of Example 1 except that the substrate W is not treated in the hydrophilization step and the second rinse step.

The substrates W treated in Example 1 and Comparative Example 1 were evaluated by collapse rate. The collapse rate is a probability that the pattern WP on the substrate W collapses. The collapse rate is, for example, a ratio of the number of collapsed projections T to the number of projections T.

The collapse rate of the substrate W treated in Example 1 was lower than the collapse rate of the substrate W treated in Comparative Example 1.

Therefore, the substrate W was dried more appropriately in Example 1 than in Comparative Example 1. The pattern WP was protected more appropriately in Example 1 than in Comparative Example 1. In Example 1, the collapse of the pattern WP was prevented more appropriately than in Comparative Example 1. In Example 1, the substrate W was dried in a state where the pattern WP was suitably protected.

### <1-7. Mechanism of protection of pattern WP>

The present inventors have studied the mechanism of protection of the pattern WP in the substrate treating method of the first embodiment. The present inventors have studied the mechanism of protection of the pattern WP in Example 1. The mechanism assumed by the present inventors will be described below.

In the first embodiment, when the drying auxiliary liquid g is supplied to the substrate W, the substrate W has the hydroxy group. In Example 1, when the drying auxiliary liquid g is supplied to the substrate W, the substrate W has the hydroxy group. In the first supplying step, when the drying auxiliary liquid g is supplied to the substrate W, the substrate W has the hydroxy group. The hydroxy group has polarity. The sublimable substance is an organic compound containing the oxime group. The oxime group also has polarity. The hydroxy group and the oxime group are hydrogen-bonded to each other. The hydroxy group and the oxime group attract each other by hydrogen bonding. Therefore, the hydroxy group and the sublimable substance attract each other by hydrogen bonding. Hydrogen bonding is a type of intermolecular force.

The intermolecular force acting between the hydroxy group and the sublimable substance is larger than the intermolecular force acting between the hydroxy group and the first solvent.

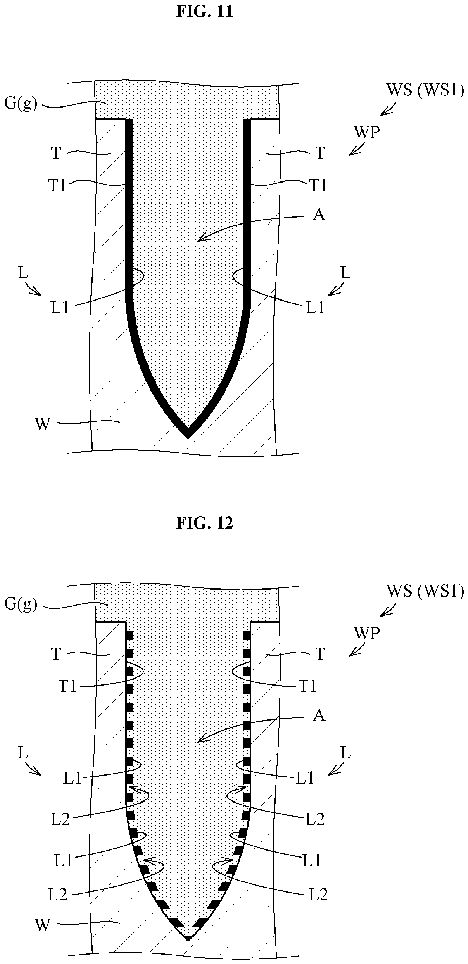

FIG. 11 is a view for describing a mechanism of protection of the pattern WP in the substrate treating method of the first embodiment. The hydroxy group is located on the surface WS. Therefore, the sublimable substance in the drying auxiliary liquid g is attracted to the surface WS. The sublimable substance in the drying auxiliary liquid g is attracted to the surface WS in preference to the first solvent. The sublimable substance in the drying auxiliary liquid g excludes the first solvent from the interface between the surface WS and the drying auxiliary liquid g. The sublimable substance in the drying auxiliary liquid g occupies the interface between the surface WS and the drying auxiliary liquid g.

The surface WS includes the side T1 of the projection T. Therefore, the hydroxy group is also located on the side T1. Therefore, the sublimable substance in the drying auxiliary liquid g is attracted to the side T1. The sublimable substance in the drying auxiliary liquid g is attracted to the side T1 in preference to the first solvent.

The interface between the side T1 and the drying auxiliary liquid g is referred to as "interface L". The sublimable substance in the drying auxiliary liquid g removes the first solvent from the interface L. The sublimable substance in the drying auxiliary liquid g occupies the interface L.

The portion of the interface L occupied by the sublimable substance is referred to as "first section L1". FIG. 11 clearly shows the first section L1 in black. FIG. 11 clearly shows the first section L1 by a thick black line. The first section L1 extends over the entire interface L. That is, the interface L is entirely occupied by the sublimable substance in the drying auxiliary liquid g. The first section L1 covers the entire side T1. That is, the entire side T1 is covered with the sublimable substance in the drying auxiliary liquid g.

In the solidified film forming step, the sublimable substance in the drying auxiliary liquid g changes into the solidified film K. As described above, the sublimable substance in the drying auxiliary liquid g occupies the interface between the surface WS and the drying auxiliary liquid g. In other words, the first solvent is not present on the interface between the surface WS and the drying auxiliary liquid g. Therefore, the first solvent does not prevent the solidified film K from being formed on the interface between the surface WS and the drying auxiliary liquid g. The first solvent does not prevent the solidified film K from being formed at a position in contact with the surface WS. Therefore, the solidified film K is suitably formed on the surface WS. The solidified film K is suitably formed at a position in contact with the surface WS.

Further, the sublimable substance in the drying auxiliary liquid g occupies the entire interface L. In other words, the first solvent is not present on the interface L. Therefore, the first solvent does not prevent the solidified film K from being formed on the interface L. The first solvent does not prevent the solidified film K from being formed at a position in contact with the side T1. Therefore, the solidified film K is suitably formed on the side T1. The solidified film K is suitably formed at a position in contact with the side T1.

Since the solidified film K is formed at a position in contact with the side T 1, the solidified film K grows appropriately in the recess A. Therefore, the drying auxiliary liquid g smoothly leaves the recess A. The first solvent smoothly leaves the recess A. Therefore, at the end of the solidified film forming step, the drying auxiliary liquid g does not remain in the recess A. At the end of the solidified film forming step, the first solvent does not remain in the recess A.

As a result, at the end of the solidified film forming step, the solidified film K is in contact with the entire side T1. The solidified film K is in surface contact with the entire side T1. Therefore, the solidified film K suitably supports the projection T. That is, the solidified film K suitably supports the pattern WP. Therefore, the solidified film K suitably protects the pattern WP. The solidified film K suitably prevents the pattern WP from collapsing.

The mechanism of protection of the pattern WP in the substrate treating method of the first embodiment will be summarized below. In the first supplying step, the drying auxiliary liquid g is appropriately supplied to the pattern WP. Specifically, the sublimable substance in the drying auxiliary liquid g is attracted to the interface L by the hydrogen bonding between the hydroxy group and the sublimable substance. The sublimable substance in the drying auxiliary liquid g appropriately enters the recess A. Therefore, in the solidified film forming step, the solidified film K is formed along the pattern WP. Therefore, the pattern WP is protected.

### <1-8. Mechanism of collapse of pattern WP>

The present inventors have studied the mechanism of collapse of the pattern WP in Comparative Example 1. The mechanism assumed by the present inventors will be described below.

The substrate treating method of Comparative Example 1 does not include the hydrophilization step. Therefore, in Comparative Example 1, the substrate W does not have the hydroxy group when the drying auxiliary liquid g is supplied to the substrate W.

Specifically, in the etching step, the substrate W is etched, and the surface WS of the substrate W is terminated with hydrogen. For example, the hydrogen atom is bonded to an atom (for example, a silicon atom) located on the surface WS. In the first rinse step, hydrogen on the surface WS is not removed. In the first replacement step, hydrogen on the surface WS is not removed. Therefore, in the Comparative Example, when the drying auxiliary liquid g is supplied to the substrate W, the substrate W contains hydrogen.

Hydrogen on the substrate W is bonded to an atom located on the surface WS. Therefore, hydrogen on the substrate W does not have polarity. Therefore, hydrogen on the substrate W and the oxime group are not hydrogen-bonded to each other. That is, hydrogen on the substrate W and the oxime group are not attracted to each other. Therefore, hydrogen on the substrate W and the sublimable substance are not attracted to each other.

FIG. 12 is a diagram illustrating a mechanism of collapse of the pattern WP. The sublimable substance is not attracted to the surface WS. The sublimable substance does not occupy the interface between the surface WS and the drying auxiliary liquid g. The sublimable substance does not remove the first solvent from the interface between the surface WS and the drying auxiliary liquid g. Therefore, not only the sublimable substance but also the first solvent is present on the interface between the surface WS and the drying auxiliary liquid g.

Especially, when the initial amount Qb is larger than the initial amount Qa, the first solvent is present in a larger amount than the sublimable substance on the interface between the surface WS and the drying auxiliary liquid g.

The sublimable substance does not occupy the interface L. The sublimable substance does not remove the first solvent from the interface L. Therefore, not only the sublimable substance but also the first solvent is present on the interface L.

The portion of the interface L not occupied by the sublimable substance is referred to as "second section L2". For example, the first solvent is present in the second section L2. As shown in FIG. 12, the interface L includes a plurality of first sections L1 and a plurality of second sections L2. The first section L1 is divided by the second section L2. The size of each first section L1 is small. The area of each first section L1 is small. The first section L1 does not extend to the entire interface L. That is, the interface L is not entirely occupied by the sublimable substance in the drying auxiliary liquid g. The first solvent is present on at least a part of the interface L. The first section L1 does not cover the entire side T1. That is, the entire side T1 is not covered with the sublimable substance in the drying auxiliary liquid g.

In the solidified film forming step, the sublimable substance in the drying auxiliary liquid g changes into the solidified film K. As described above, the sublimable substance in the drying auxiliary liquid g does not occupy the interface between the surface WS and the drying auxiliary liquid g. In other words, the first solvent is present on the interface between the surface WS and the drying auxiliary liquid g. Therefore, the first solvent prevents the solidified film K from being formed on the interface between the surface WS and the drying auxiliary liquid g. The first solvent prevents the solidified film K from being formed at a position in contact with the surface WS. Therefore, the solidified film K is not suitably formed on the surface WS. The solidified film K is not suitably formed at a position in contact with the surface WS.

Further, the sublimable substance in the drying auxiliary liquid g does not occupy the entire interface L. In other words, the first solvent is present on the interface L (for example, the second section L2). Therefore, the first solvent prevents the solidified film K from being formed on the interface L. The first solvent prevents the solidified film K from being formed at a position in contact with the side T1. Especially, the solidified film K is less likely to be formed in the second section L2. Therefore, the solidified film K is not suitably formed on the side T1. The solidified film K is not suitably formed at a position in contact with the side T1.

Since the solidified film K is not formed at a position in contact with the side T1, the solidified film K does not grow appropriately in the recess A. Therefore, the drying auxiliary liquid g does not smoothly leave the recess A. The first solvent does not smoothly leave the recess A. Therefore, at the end of the solidified film forming step, the drying auxiliary liquid g may remain in the recess A. At the end of the solidified film forming step, the first solvent may remain in the recess A.

As a result, at the end of the solidified film forming step, the solidified film K is not in contact with the entire side T1. The solidified film K is in contact with only a part of the side T1. Therefore, the solidified film K does not suitably support the projection T. That is, the solidified film K does not suitably support the pattern WP. Therefore, the solidified film K does not sufficiently protect the pattern WP. The solidified film K does not sufficiently prevent the pattern WP from collapsing.

The mechanism of collapse of the pattern WP is summarized below. The drying auxiliary liquid g is not appropriately supplied to the pattern WP. Specifically, the sublimable substance in the drying auxiliary liquid g is not attracted to the interface L. The sublimable substance in the drying auxiliary liquid g does not appropriately enter the recess A. Therefore, the solidified film K is not formed along the pattern WP. Thus, the pattern WP is not protected.

### <1-9. Effect of first embodiment>

The substrate treating method of the first embodiment is for treating the substrate W. The substrate W has the pattern WP formed on the surface WS. The substrate treating method includes the hydrophilization step, the first supplying step, the solidified film forming step, and the sublimation step. In the hydrophilization step, the hydroxy group is formed on the surface WS. In the first supplying step, the drying auxiliary liquid g is supplied to the substrate W having the hydroxy group. The drying auxiliary liquid g contains the sublimable substance and the first solvent. In the solidified film forming step, the first solvent evaporates from the drying auxiliary liquid g on the substrate W. In the solidified film forming step, the solidified film K is formed on the substrate W. The solidified film K contains a sublimable substance. In the sublimation step, the solidified film K is sublimated. The substrate W is dried by the sublimation of the solidified film K.

Here, the sublimable substance contains the organic compound containing the oxime group. Therefore, in the first supplying step, the drying auxiliary liquid g is appropriately supplied to the pattern WP.

According to the mechanism assumed by the present inventors, in the first supplying step, a hydroxy group is located on the surface WS. In the first supplying step, the hydroxy group is located in the pattern WP. The sublimable substance contains the oxime group. Therefore, the sublimable substance and the hydroxy group attract each other by interaction (specifically, hydrogen bonding). Therefore, in the first supplying step, the sublimable substance in the drying auxiliary liquid g is attracted to the surface WS. In the first supplying step, the sublimable substance in the drying auxiliary liquid g is attracted to the pattern WP. Therefore, in the first supplying step, the drying auxiliary liquid g is appropriately supplied to the pattern WP.

As a result, in the solidified film forming step, the solidified film K is appropriately formed along the pattern WP. This is because the solidified film K contains the sublimable substance. The solidified film K suitably supports the pattern WP. The solidified film K appropriately prevents the pattern WP from collapsing. The substrate W is dried in a state where the pattern WP is suitably protected.

As described above, according to the substrate treating method of the first embodiment, the substrate W is appropriately dried.

According to the mechanism assumed by the present inventors, in the first supplying step, the sublimable substance is attracted to the pattern WP by intermolecular force. Therefore, even when the pattern WP is fine, the drying auxiliary liquid g is also appropriately supplied to the pattern WP. Even when the size of the recess A is minute, the drying auxiliary liquid g is also appropriately supplied to the recess A. Even when the separation distance between two adjacent projections T is minute, the drying auxiliary liquid g is also appropriately supplied to the recess A. Therefore, as the pattern WP becomes finer, the usefulness of appropriately supplying the drying auxiliary liquid g to the recess A becomes remarkably large.

As described above, in the first supplying step, the substrate W has the hydroxy group. Therefore, in the first supplying step, the surface WS is hydrophilic. In the first supplying step, the pattern WP is hydrophilic. If the pattern WP intersects with the gas-liquid interface, surface tension acts on the pattern WP. When the pattern WP is hydrophilic, the surface tension acting on the pattern WP is greater. Therefore, in the first supplying step, the substrate W having the hydroxy group may hinder the protection of the pattern WP. That is, the first supplying step may have a problem that hinders the protection of the pattern WP. Therefore, it seems to be difficult for a person skilled in the art to adopt the first supplying step. However, the substrate treating method of the first embodiment intentionally adopts the first supplying step. The reason is that the present inventors have found that a combination of the first supplying step and a specific sublimable substance produces a significant effect. Here, the specific sublimable substance is the sublimable substance containing the organic compound containing the oxime group. The significant effect is that the drying auxiliary liquid g is appropriately supplied to the pattern WP.

Further, the substrate treating method of the first embodiment does not include a step of adhering a water repellent to the surface WS of the substrate W. The substrate treating method of the first embodiment does not include a step of hydrophobizing the substrate W. Therefore, the number of steps included in the substrate treating method of the first embodiment is suitably reduced. Therefore, the time for executing the substrate treating method of the first embodiment is suitably shortened. Further, the substrate treating method of the first embodiment does not use a water repellent. Therefore, the cost for executing the substrate treating method of the first embodiment is effectively reduced.

In the hydrophilization step, APM is supplied to the substrate W. Therefore, in the hydrophilization step, the hydroxy group is appropriately formed on the surface WS.

The substrate treating method of the first embodiment includes the etching step. The etching step is executed before the hydrophilization step. In the etching step, the etching liquid is supplied to the substrate W. In the etching step, the oxide film on the substrate W is removed. Therefore, in the hydrophilization step, the hydroxy group is more appropriately formed on the surface WS. For example, in the hydrophilization step, the hydroxy group is uniformly formed on the entire surface WS.

The substrate treating method of the first embodiment includes the first rinse step. The first rinse step is executed after the etching step and before the hydrophilization step. In the first rinse step, the first rinse liquid is supplied to the substrate W. Therefore, in the first rinse step, the etching liquid is suitably removed from the substrate W. Therefore, in the hydrophilization step, the hydroxy group is more appropriately formed on the surface WS.

The substrate treating method of the first embodiment includes the second rinse step. The second rinse step is executed after the hydrophilization step and before the first supplying step. In the second rinse step, the second rinse liquid is supplied to the substrate W. Therefore, in the second rinse step, the substrate W is appropriately cleaned. For example, in the second rinse step, the hydrophilic agent is suitably removed from the substrate W. Therefore, in the first supplying step, the drying auxiliary liquid g is more appropriately supplied to the pattern WP.

The substrate treating method of the first embodiment includes the first replacement step. The first replacement step is executed after the second rinse step and before the first supplying step. In the first replacement step, the first replacement liquid is supplied to the substrate. Therefore, in the first replacement step, the second rinse liquid is suitably removed from the substrate. Therefore, in the first supplying step, the drying auxiliary liquid g is more appropriately supplied to the pattern WP.

The sublimable substance does not contain a fluorocarbon compound. Therefore, in the first supplying step, the drying auxiliary liquid g is more appropriately supplied to the pattern WP.

The sublimable substance contains, for example, at least one of cyclohexanone oxime and pinacoline oxime. Therefore, in the first supplying step, the drying auxiliary liquid g is more appropriately supplied to the pattern WP.

The substrate treating apparatus 1 of the first embodiment includes the substrate holder 13, the third supplying unit 15c, and the first supplying unit 15a. The substrate holder 13 holds the substrate W. The third supplying unit 15c forms the hydroxy group on the substrate W held by the substrate holder 13. The first supplying unit 15a supplies the drying auxiliary liquid g to the substrate W held by the substrate holder 13. The drying auxiliary liquid g contains the sublimable substance and the first solvent. Therefore, when the first supplying unit 15a supplies the drying auxiliary liquid g to the substrate W, the first solvent evaporates from the drying auxiliary liquid g on the substrate W. The solidified film K is formed on the substrate W by the evaporation of the first solvent. The solidified film K contains a sublimable substance. Therefore, the solidified film K is sublimated. The substrate W is dried by the sublimation of the solidified film K.

Here, the sublimable substance contains the organic compound containing the oxime group. Therefore, the drying auxiliary liquid g is appropriately supplied to the pattern WP. As a result, the solidified film K is appropriately formed along the pattern WP. The solidified film K suitably supports the pattern WP. The solidified film K appropriately prevents the pattern WP from collapsing. The substrate W is dried in a state where the pattern WP is suitably protected.

As described above, according to the substrate treating apparatus 1 of the first embodiment, the substrate W is appropriately dried.

### <2. Second embodiment>

A second embodiment will be described with reference to the drawings. The same configurations as those of the first embodiment are denoted by the same reference signs, and detailed description thereof will be omitted.

### <2-1. Configuration of treating unit 11>

The outline of the substrate treating apparatus 1 of the second embodiment is substantially the same as that of the first embodiment. Hereinafter, a configuration of the treating unit 11 of the second embodiment will be described.

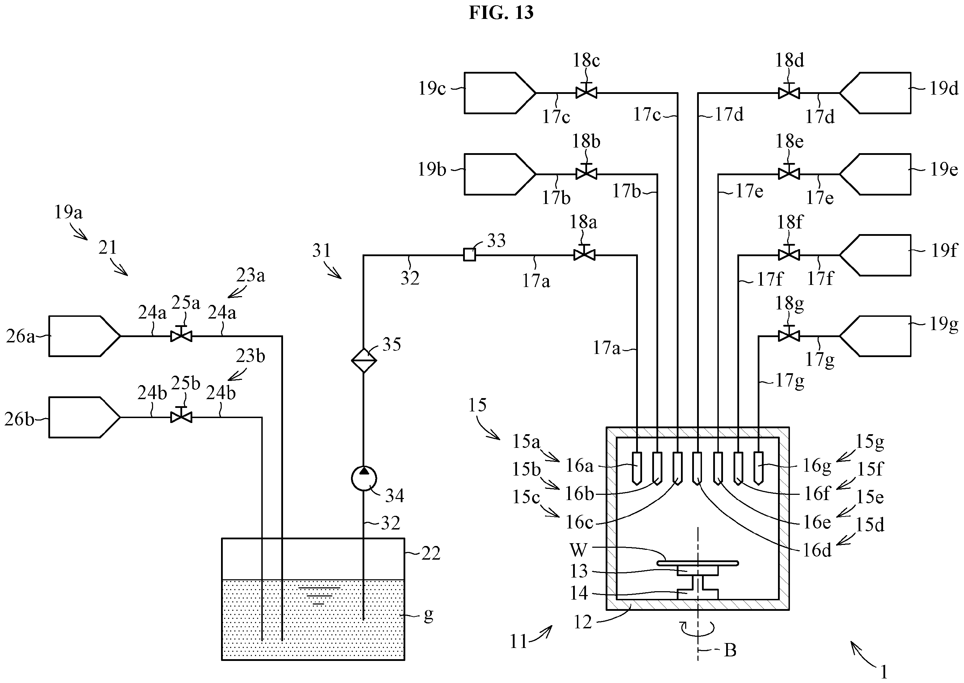

FIG. 13 is a diagram showing the configuration of the treating unit 11 and the first supplying source 19a of the second embodiment.

The supplying unit 15 includes a seventh supplying unit 15g in addition to the first to sixth supplying units 15a to 15f. The seventh supplying unit 15g supplies the water repellent. The seventh supplying unit 15g supplies, for example, a mixed liquid containing the water repellent. The mixed liquid is a liquid.

The water repellent supplied by the seventh supplying unit 15g contains, for example, at least one of a silicon-based water repellent and a metal-based water repellent. The silicon-based water repellent causes silicon to be water-repellent. The silicon-based water repellent causes a compound containing silicon to be water-repellent. The silicon-based water repellent causes a film containing silicon to be water-repellent. The silicon-based water repellent is also called a silane-based water repellent. The metal-based water repellent causes metal to be water-repellent. The metal-based water repellent causes a compound containing metal to be water-repellent. The metal-based water repellent causes a metal film to be water-repellent.

The silicon-based water repellent is, for example, a silane coupling agent. The silane coupling agent contains, for example, at least one of hexamethyldisilazane (HMDS), tetramethylsilane (TMS), fluorinated alkylchlorosilane, alkyldisilazane, and a non-chloro-based water repellent. The non-chloro-based water repellent contains, for example, at least one of dimethylsilyldimethylamine, dimethylsilyldiethylamine, hexamethyldisilazane, tetramethyldisilazane, bis (dimethylamino) dimethylsilane, N, N-dimethylaminotrimethylsilane, N-(trimethylsilyl) dimethylamine, and an organosilane compound. Alternatively, the silicon-based water repellent contains at least one of 3-aminopropyltriethoxysilane (APTES), benzyltrichlorosilane, 11-cyanoundecyltrichlorosilane, 11-iodoundecyltrichlorosilane, 11-bromoundecyltrichlorosilane, 11-Chloroundecyltrichlorosilane, N-Undecyltrichlorosilane, and 1H, 1H, 2H, 2H-perfluorodecyltrichlorosilane (FDTS).

The metal-based water repellent contains, for example, at least one of an amine having a hydrophobic group and an organic silicon compound.

The mixed liquid supplied by the seventh supplying unit 15g contains the second solvent in addition to the water repellent. The second solvent has solubility with respect to the water repellent, for example. The second solvent dilutes the water repellent, for example. The second solvent contains, for example, an organic solvent. The second solvent contains, for example, at least one of IPA and propylene glycol monomethyl ether acetate (PGMEA).

It is preferable that the mixed liquid does not contain water. The mixed liquid is composed of, for example, only the water repellent and the second solvent. For example, the mixed liquid is composed of only hexamethyldisilazane and propylene glycol monomethyl ether acetate. Hereinafter, hexamethyldisilazane is referred to as "HMDS". Propylene glycol monomethyl ether acetate is referred to as "PGMEA" .

The drying auxiliary liquid g supplied by the first supplying unit 15a does not contain a water repellent. The rinse liquid supplied by the fourth supplying unit 15d does not contain a water repellent. The replacement liquid supplied by the fifth supplying unit 15e does not contain a water repellent. The replacement liquid has solubility with respect to the mixed liquid. The replacement liquid is compatible with the mixed liquid.

The seventh supplying unit 15g includes a nozzle 16g, a pipe 17g, and a valve 18g. The nozzle 16g is installed inside the housing 12. The nozzle 16g dispenses the mixed liquid. The pipe 17g is connected to the nozzle 16g. At least a part of the pipe 17g may be provided outside the housing 12. The valve 18g is provided on the pipe 17g. The valve 18g may be provided outside the housing 12. The valve 18g controls the dispense of the mixed liquid.

The seventh supplying unit 15g communicates with a seventh supplying source 19g. The seventh supplying unit 15g is connected to the seventh supplying source 19g. The seventh supplying source 19g is connected to, for example, the pipe 17g. The seventh supplying source 19g is provided outside the housing 12. The seventh supplying source 19g supplies the mixed liquid to the seventh supplying unit 15g. The seventh supplying source 19g may be a component of the substrate treating apparatus 1. The seventh supplying source 19g may not be a component of the substrate treating apparatus 1.

The seventh supplying unit 15g is an example of a hydrophobization unit of the present invention.

Although not shown, the controller 10 controls the seventh supplying unit 15g. The controller 10 controls the valve 18g.

### <2-2. Operation example of first supplying source 19a and treating unit 11>

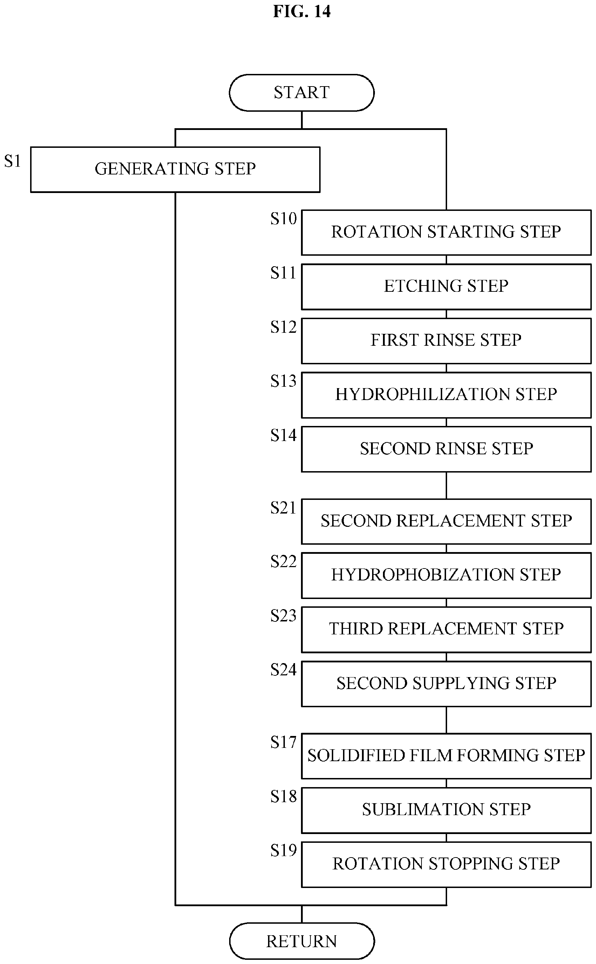

FIG. 14 is a flowchart showing a procedure of the substrate treating method of the second embodiment. The substrate treating method of the second embodiment includes Steps S21 to S24 instead of Steps S15 and S16 of the first embodiment. In detail, the substrate treating method of the second embodiment includes Step S1 and Steps S10 to S14, S17 to S19, and S21 to S24. After Steps S10 to S14, Steps S21 to S24 are executed. Steps S21 to S24 are executed in this order. Steps S21 to S24 are substantially executed by the treating unit 11. After Steps S21 to S24, Steps S16 to S19 are executed.

The operations of Steps S1, S10 to S14, and S16 to S19 are substantially common between the first embodiment and the second embodiment. Therefore, the description of the operations of Steps S1, S10 to S14, and S16 to S19 will be omitted. The operations of Steps S21 to S24 will be described.

### Step S21: Second replacement step

After the second rinse step, a second replacement step is executed. In the second replacement step, the replacement liquid is supplied to the substrate W. In the second replacement step, the replacement liquid is supplied to the substrate W having the hydroxy group. In the present description, the replacement liquid supplied to the substrate W in the second replacement step is referred to as "second replacement liquid".

The fifth supplying unit 15e supplies the second replacement liquid to the substrate W held by the substrate holder 13. Specifically, the valve 18e opens. The nozzle 16e dispenses the second replacement liquid. The second replacement liquid is supplied to the surface WS (specifically, the first surface WS1).

In the following description, the surface WS specifically means the first surface WS1. That is, in the following description, the "surface WS" is synonymous with the "surface WS (specifically, the first surface WS1)".

The second replacement liquid removes the second rinse liquid on the substrate W. The second rinse liquid on the substrate W is removed from the substrate W. The second rinse liquid on the substrate W is replaced with the second replacement liquid. The second replacement liquid is in contact with the surface WS.

The hydroxy group formed on the surface of the substrate W is not removed by the second replacement liquid. After the second replacement step, the substrate W also has the hydroxy group formed on the surface WS.

Thereafter, the fifth supplying unit 15e stops supplying the second replacement liquid to the substrate W. Specifically, the valve 18e is closed. The nozzle 16e stops dispensing the second replacement liquid.

### Step S22: Hydrophobization step

After the second replacement step, a hydrophobization step is executed. In the hydrophobization step, the substrate W has the hydroxy group. In the hydrophobization step, the water repellent is supplied to the substrate W. In the hydrophobization step, for example, the mixed liquid is supplied to the substrate W. The mixed liquid contains the water repellent and the second solvent. In the hydrophobization step, the water repellent is adhered to the surface WS of the substrate W.

The seventh supplying unit 15g supplies the mixed liquid to the substrate W held by the substrate holder 13. Specifically, the valve 18g opens. The nozzle 16g dispenses the mixed liquid. The mixed liquid is supplied to the surface WS.

The mixed liquid removes the second replacement liquid on the substrate W. The second replacement liquid on the substrate W is removed from the substrate W. The second replacement liquid on the substrate W is replaced with the mixed liquid. The mixed liquid is in contact with the surface WS.

The water repellent contained in the mixed liquid adheres to the surface WS. For example, the water repellent adheres to the surface WS by at least one of chemical adsorption and physical adsorption. When the water repellent adheres to the surface WS by chemical adsorption, the water repellent is chemically bonded to the surface WS, for example. When the water repellent adheres to the surface WS by physical adsorption, the water repellent may not be chemically bonded to the surface WS.

For example, the water repellent forms a water-repellent film on the surface WS. The water-repellent film adheres to the surface WS. The water-repellent film adheres to the surface WS by at least one of chemical adsorption and physical adsorption. When the water-repellent film adheres to the surface WS by chemical adsorption, the water-repellent film is chemically bonded to the surface WS, for example. When the water-repellent film adheres to the surface WS by physical adsorption, the water-repellent film may not be chemically bonded to the surface WS.

At least a part of the water repellent contained in the mixed liquid adheres to the surface WS. For example, only a part of the water repellent contained in the mixed liquid may adhere to the surface WS. For example, another part of the water repellent contained in the mixed liquid may not adhere to the surface WS. Here, the water repellent which is contained in the mixed liquid and does not adhere to the surface is particularly referred to as "unreacted portion of the water repellent".

One molecule of the water repellent may entirely adhere to the surface WS. Only a part of one molecule of the water repellent may adhere to the surface WS. A part of one molecule of the water repellent corresponds to, for example, a hydrophobic group. For example, the molecules of the water repellent may have hydrophobic groups, and only the hydrophobic groups may adhere to the surface WS.

When the water repellent is HMDS, HMDS reacts with the hydroxy group formed on the surface WS. The hydroxy group on the surface WS changes into a trimethylsiloxy group (-OSi(CH3)3). Here, the trimethylsiloxy group corresponds to the hydrophobic group. The trimethylsiloxy group contains a part of one molecule of HMDS.

The water repellent adheres to the surface WS, and thus the surface WS becomes hydrophobic.

As described above, the seventh supplying unit 15g causes the water repellent to adhere to the surface WS of the substrate W held by the substrate holder 13.

Thereafter, the seventh supplying unit 15g stops supplying the mixed liquid to the substrate W. Specifically, the valve 18g is closed. The nozzle 16g stops dispensing the mixed liquid.

### Step S23: Third replacement step

After the hydrophobization step, a third replacement step is executed. In the third replacement step, the replacement liquid is supplied to the substrate W. In the third replacement step, the replacement liquid is supplied to the substrate W to which the water repellent adheres. In the present description, the replacement liquid supplied to the substrate W in the third replacement step is referred to as "third replacement liquid".

In the second embodiment, the third replacement liquid is the same type as the second replacement liquid. The composition of the third replacement liquid is, for example, the same as the composition of the second replacement liquid. For example, the second replacement liquid and the third replacement liquid are both IPA.

The fifth supplying unit 15e supplies the third replacement liquid to the substrate W held by the substrate holder 13. Specifically, the valve 18e opens. The nozzle 16e dispenses the third replacement liquid. The third replacement liquid is supplied to the surface WS.

The third replacement liquid removes the mixed liquid on the substrate W. The third replacement liquid removes, for example, the unreacted portion of the water repellent. The mixed liquid on the substrate W is removed from the substrate W. The unreacted portion of the water repellent is removed from the substrate W. The mixed liquid on the substrate W is replaced with the third replacement liquid. The third replacement liquid is in contact with the surface WS.

The water repellent adhering to the surface WS of the substrate W is not removed by the third replacement liquid. After the third replacement step, the substrate W also has the water repellent adhering to the surface WS.

Thereafter, the fifth supplying unit 15e stops supplying the third replacement liquid to the substrate W. Specifically, the valve 18e is closed. The nozzle 16e stops dispensing the third replacement liquid.

### Step S24: Second supplying step

A second supplying step is similar to the first supplying step of the first embodiment. Therefore, the second supplying step will be briefly described.

After the third replacement step, the second supplying step is executed. In the second supplying step, the drying auxiliary liquid g is supplied to the substrate W. In the second supplying step, the drying auxiliary liquid g is supplied to the substrate W to which the water repellent adheres. The water repellent is located on the surface WS.

The pressure feed unit 31 supplies the drying auxiliary liquid g to the first supplying unit 15a. The first supplying unit 15a supplies the drying auxiliary liquid g to the substrate W held by the substrate holder 13.

The drying auxiliary liquid g removes the third replacement liquid on the substrate W. The third replacement liquid on the substrate W is removed from the substrate W. The third replacement liquid on the substrate W is replaced with the drying auxiliary liquid g. The drying auxiliary liquid g is in contact with the surface WS.

Thereafter, the pressure feed unit 31 stops supplying the drying auxiliary liquid g to the first supplying unit 15a. The first supplying unit 15a stops supplying the drying auxiliary liquid g to the substrate W.

### <2-3. Technical significance of hydrophobization step>

The technical significance of the hydrophobization step will be described by Example 2 and Comparative Example 1. In Example 2, the substrate W is treated by the substrate treating method including the hydrophobization step. Comparative Example 1 is described in "1-6. Technical Significance of hydrophilization Step" of the first embodiment. The substrate treating method of Comparative Example 1 does not include the hydrophobization step.

The conditions of Example 2 will be described. In Example 2, the substrate W is treated in the etching step, the first rinse step, the hydrophilization step, the second rinse step, the second replacement step, the hydrophobization step, the third replacement step, the second supplying step, the solidified film forming step, and the sublimation step. The etching liquid is hydrofluoric acid (HF). The first rinse liquid is deionized water (DIW). The hydrophilic agent is APM. The second rinse liquid is deionized water (DIW). The second replacement liquid is IPA. The water repellent of the mixed liquid is HMDS. The second solvent of the mixed liquid is PGMEA. The third replacement liquid is IPA. The sublimable substance of the drying auxiliary liquid g is cyclohexanone oxime. The first solvent of the drying auxiliary liquid g is IPA.

The substrates W treated in Example 2 and Comparative Example 1 were evaluated by collapse rate.

The collapse rate of the substrate W treated in Example 2 was lower than the collapse rate of the substrate W treated in Comparative Example 1. The collapse rate of the substrate W treated in Example 2 was substantially the same as the collapse rate of the substrate W treated in Example 1.

Therefore, in Example 2, the substrate W was dried more appropriately than in Comparative Example 2. In Example 2, the pattern WP was protected more appropriately than in Comparative Example 1. In Example 2, the collapse of the pattern WP was prevented more appropriately than in Comparative Example 1. In Example 2, the substrate W was dried in a state where the pattern WP was suitably protected. In Example 2, the substrate W was dried as appropriately as in Example 1.

### <2-4. Mechanism of protection of pattern WP>

The present inventors have studied the mechanism of protection of the pattern WP in the substrate treating method of the second embodiment. The present inventors have studied the mechanism of protection of the pattern WP in Example 2. The mechanism assumed by the present inventors will be described below.

In the second embodiment, when the drying auxiliary liquid g is supplied to the substrate W, the substrate W has the water repellent. In Example 2, when the drying auxiliary liquid g is supplied to the substrate W, the substrate W has the water repellent. In the second supplying step, when the drying auxiliary liquid g is supplied to the substrate W, the substrate W has the water repellent. The molecular weight of the water repellent is relatively large. The size of one molecule of the water repellent is relatively large. For example, the molecular weight of the water repellent is larger than the molecular weight of hydrogen atom. For example, the water repellent includes a carbon chain. For example, the water repellent is a chain compound. For example, the water repellent is a linear chain compound. For example, the water repellent is a branched compound. Therefore, the van der Waals force acting between the water repellent and the sublimable substance is large. The water repellent and the sublimable substance attract each other by van der Waals force. Van der Waals force is a type of intermolecular force.

The intermolecular force acting between the water repellent and the sublimable substance is larger than the intermolecular force acting between the water repellent and the first solvent.

For convenience, reference is made to FIG. 11. The water repellent is located on the surface WS. Therefore, the sublimable substance in the drying auxiliary liquid g is attracted to the surface WS. The sublimable substance in the drying auxiliary liquid g is attracted to the surface WS in preference to the first solvent. The sublimable substance in the drying auxiliary liquid g excludes the first solvent from the interface between the surface WS and the drying auxiliary liquid g. The sublimable substance in the drying auxiliary liquid g occupies the interface between the surface WS and the drying auxiliary liquid g.

The water repellent is also located on the side T1 of the projection T. Therefore, the sublimable substance in the drying auxiliary liquid g is attracted to the side T1. The sublimable substance is attracted to the side T1 in preference to the first solvent. The sublimable substance excludes the first solvent from the interface L between the side T1 and the drying auxiliary liquid g. The sublimable substance occupies the entire interface L. As described above, the first section L1 is a portion of the interface L occupied by the sublimable substance. The first section L1 extends over the entire interface L. The first section L1 covers the entire side T1.

In the solidified film forming step, the sublimable substance in the drying auxiliary liquid g changes into the solidified film K. As described above, the sublimable substance in the drying auxiliary liquid g occupies the interface between the surface WS and the drying auxiliary liquid g. In other words, the first solvent is not present on the interface between the surface WS and the drying auxiliary liquid g. Therefore, the first solvent does not prevent the solidified film K from being formed on the interface between the surface WS and the drying auxiliary liquid g. The first solvent does not prevent the solidified film K from being formed at a position in contact with the surface WS. Therefore, the solidified film K is suitably formed on the surface WS. The solidified film K is suitably formed at a position in contact with the surface WS.

Further, the sublimable substance in the drying auxiliary liquid g occupies the entire interface L. In other words, the first solvent is not present on the interface L. Therefore, the first solvent does not prevent the solidified film K from being formed on the interface L. The first solvent does not prevent the solidified film K from being formed at a position in contact with the side T1. Therefore, the solidified film K is suitably formed on the side T1. The solidified film K is suitably formed at a position in contact with the side T1.

Since the solidified film K is formed at a position in contact with the side T1, the solidified film K grows appropriately in the recess A. Therefore, the drying auxiliary liquid g smoothly leaves the recess A. The first solvent smoothly leaves the recess A. Therefore, at the end of the solidified film forming step, the drying auxiliary liquid g does not remain in the recess A. At the end of the solidified film forming step, the first solvent does not remain in the recess A.

As a result, at the end of the solidified film forming step, the solidified film K is in contact with the entire side T1. The solidified film K is in surface contact with the entire side T1. Therefore, the solidified film K suitably supports the projection T. That is, the solidified film K suitably supports the pattern WP. Therefore, the solidified film K suitably protects the pattern WP. The solidified film K suitably prevents the pattern WP from collapsing.

The mechanism of protection of the pattern WP in the substrate treating method of the second embodiment will be summarized below. In the second supplying step, the drying auxiliary liquid g is appropriately supplied to the pattern WP. Specifically, the sublimable substance in the drying auxiliary liquid g is attracted to the interface L by the van der Waals force between the water repellent and the sublimable substance. The sublimable substance in the drying auxiliary liquid g appropriately enters the recess A. Therefore, in the solidified film forming step, the solidified film K is formed along the pattern WP. Therefore, the pattern WP is protected.

### <2-5. Effect of second embodiment>

The substrate treating method of the second embodiment is for treating the substrate W. The substrate W has the pattern WP formed on the surface WS. The substrate treating method includes the hydrophobization step, the second supplying step, the solidified film forming step, and the sublimation step. In the hydrophobization step, the water repellent adheres to the surface WS. In the second supplying step, the drying auxiliary liquid g is supplied to the substrate W to which the water repellent adheres. The drying auxiliary liquid g contains the sublimable substance and the first solvent. In the solidified film forming step, the first solvent evaporates from the drying auxiliary liquid g on the substrate W. In the solidified film forming step, the solidified film K is formed on the substrate W. The solidified film K contains a sublimable substance. In the sublimation step, the solidified film K is sublimated. The substrate is dried by the sublimation of the solidified film K.

Here, the sublimable substance contains the organic compound containing the oxime group. Therefore, in the second supplying step, the drying auxiliary liquid g is appropriately supplied to the pattern WP.

According to the mechanism assumed by the present inventors, the water repellent is located on the surface WS in the second supplying step. In the second supplying step, the water repellent is located in the pattern WP. Therefore, the sublimable substance and the water repellent attract each other by interaction (specifically, van der Waals force). Therefore, in the second supplying step, the sublimable substance in the drying auxiliary liquid g is attracted to the surface WS. In the second supplying step, the sublimable substance in the drying auxiliary liquid g is attracted to the pattern WP. Therefore, in the second supplying step, the drying auxiliary liquid g is appropriately supplied to the pattern WP.

As a result, in the solidified film forming step, the solidified film K is appropriately formed along the pattern WP. This is because the solidified film K contains the sublimable substance. The solidified film K suitably supports the pattern WP. The solidified film K appropriately prevents the pattern WP from collapsing. The substrate W is dried in a state where the pattern WP is suitably protected.

As described above, according to the substrate treating method of the second embodiment, the substrate W is appropriately dried.

In the second supplying step, the substrate W has the water repellent. Therefore, in the second supplying step, the surface WS is hydrophobic. In the second supplying step, the pattern WP is hydrophobic. If the pattern WP intersects with the gas-liquid interface, surface tension acts on the pattern WP. However, when the pattern WP is hydrophobic, the surface tension acting on the pattern WP is smaller. Therefore, from the second supplying step to the sublimation step, if the pattern WP intersects with the gas-liquid interface, the surface tension acting on the pattern WP is also suppressed, and the collapse of the pattern WP is also suppressed. If the pattern WP intersects with the gas-liquid interface from the second supplying step to the sublimation step, the surface tension acting on the pattern WP is also small, and the pattern WP is also less likely to collapse.

In the hydrophobization step, the mixed liquid is supplied to the substrate W. The mixed liquid contains the water repellent and the second solvent. Therefore, in the hydrophobization step, the water repellent contained in the mixed liquid is suitably supplied to the substrate W. Therefore, in the hydrophobization step, the water repellent contained in the mixed liquid suitably adheres to the substrate W.

The substrate treating method of the second embodiment includes the hydrophilization step. The hydrophilization step is executed before the hydrophobization step. In the hydrophilization step, the hydroxy group is formed on the surface WS. Therefore, in the hydrophobization step, the surface WS has the hydroxy group. Therefore, in the hydrophobization step, the water repellent more suitably adheres to the surface of the substrate. For example, in the hydrophobization step, the water repellent suitably reacts with the hydroxy group on the surface WS. For example, in the hydrophobization step, the water repellent uniformly adheres to the entire surface WS.

The substrate treating method of the second embodiment includes the etching step. The etching step is executed before the hydrophilization step. In the etching step, the etching liquid is supplied to the substrate W. In the etching step, the oxide film on the substrate W is removed. Therefore, in the hydrophilization step, the hydroxy group is appropriately formed on the surface WS. For example, in the hydrophilization step, the hydroxy group is uniformly formed on the entire surface WS.

The substrate treating method of the second embodiment includes the first rinse step. The first rinse step is executed after the etching step and before the hydrophilization step. In the first rinse step, the first rinse liquid is supplied to the substrate W. Therefore, in the first rinse step, the etching liquid is suitably removed from the substrate W. Therefore, in the hydrophilization step, the hydroxy group is more appropriately formed on the surface WS.

The substrate treating method of the second embodiment includes the second rinse step. The second rinse step is executed after the hydrophilization step and before the hydrophobization step. In the second rinse step, the second rinse liquid is supplied to the substrate W. Therefore, in the second rinse step, the substrate W is appropriately cleaned. For example, in the second rinse step, the hydrophilic agent is suitably removed from the substrate W. Therefore, in the hydrophobization step, the water repellent more suitably adheres to the substrate W.

The substrate treating method of the second embodiment includes the second replacement step. The second replacement step is executed after the second rinse step and before the hydrophobization step. In the second replacement step, the second replacement liquid is supplied to the substrate W. Therefore, in the second replacement step, the second rinse liquid is removed from the substrate W. Therefore, in the hydrophobization step, the water repellent more suitably adheres to the substrate W.

The substrate treating method of the second embodiment includes the third replacement step. The third replacement step is executed after the hydrophobization step and before the second supplying step. In the third replacement step, the third replacement liquid is supplied to the substrate W. Therefore, the substrate W is appropriately cleaned in the third replacement step. For example, in the third replacement step, the unreacted portion of the water repellent is suitably removed from the substrate W. For example, in the third replacement step, the mixed liquid is suitably removed from the substrate W. Therefore, in the second supplying step, the drying auxiliary liquid g is more appropriately supplied to the pattern WP.

The sublimable substance does not contain a fluorocarbon compound. Therefore, in the second supplying step, the drying auxiliary liquid g is more appropriately supplied to the pattern WP.

The sublimable substance contains, for example, at least one of cyclohexanone oxime and pinacoline oxime. Therefore, in the second supplying step, the drying auxiliary liquid g is more appropriately supplied to the pattern WP.

The substrate treating apparatus 1 of the second embodiment includes the substrate holder 13, the seventh supplying unit 15g, and the first supplying unit 15a. The substrate holder 13 holds the substrate W. The seventh supplying unit 15g causes the water repellent to adhere to the surface WS of the substrate W held by the substrate holder 13. The first supplying unit 15a supplies the drying auxiliary liquid g to the substrate W held by the substrate holder 13. The drying auxiliary liquid g contains the sublimable substance and the first solvent. Therefore, when the first supplying unit 15a supplies the drying auxiliary liquid g to the substrate W, the first solvent evaporates from the drying auxiliary liquid g on the substrate W. The solidified film K is formed on the substrate W by the evaporation of the first solvent. The solidified film K contains a sublimable substance. Therefore, the solidified film K is sublimated. The substrate W is dried by the sublimation of the solidified film K.

Here, the sublimable substance contains the organic compound containing the oxime group. Therefore, the drying auxiliary liquid g is appropriately supplied to the pattern WP. As a result, the solidified film K is appropriately formed along the pattern WP. The solidified film K suitably supports the pattern WP. The solidified film K appropriately prevents the pattern WP from collapsing. The substrate W is dried in a state where the pattern WP is suitably protected.

As described above, according to the substrate treating apparatus 1 of the second embodiment, the substrate W is appropriately dried.

### <3. Modifications>

The present invention is not limited to the first and second embodiments, and can be modified as follows.

(1) In the first and second embodiments, cyclohexanone oxime and pinacoline oxime are exemplified as the organic compounds containing the oxime group. However, the present invention is not limited thereto. The organic compound containing the oxime group may be a compound other than cyclohexanone oxime and pinacoline oxime. The sublimable substance may contain an organic compound containing the oxime group other than cyclohexanone oxime and pinacoline oxime.
(2) In the hydrophilization step of the first and second embodiments, APM is exemplified as the hydrophilic agent. However, the present invention is not limited thereto. For example, the hydrophilic agent may be ozone water. According to this modification, the hydroxy group can be also suitably formed on the surface WS.
   The configuration of the third supplying unit 15c is appropriately changed according to the change of the hydrophilic agent.
(3) In the hydrophilization step of the first and second embodiments, the hydrophilic agent is supplied to the substrate W. However, the present invention is not limited thereto. For example, in the hydrophilization step, at least one of UV treatment, plasma treatment, and ozone baking may be executed on the substrate W. In the UV treatment, the substrate W is irradiated with ultraviolet light. In the plasma treatment, plasma of a treating gas is supplied to the substrate W. In the ozone baking, an ozone gas is supplied to the substrate W with the substrate W being heated. According to this modification, the hydroxy group can be also suitably formed on the surface WS.
   The configuration of the treating unit 11 is appropriately changed in accordance with the change of the hydrophilization step. For example, the treating unit 11 may include an irradiation unit that irradiates the substrate W with ultraviolet light. For example, the treating unit 11 may include a plasma generating unit that generates plasma. For example, the treating unit 11 may include a heating unit that heats the substrate W. For example, the treating unit 11 may include a gas supplying unit that supplies the ozone gas to the substrate W.
(4) In the hydrophobization step of the second embodiment, the liquid of the water repellent is supplied to the substrate W. In the hydrophobization step of the second embodiment, the mixed liquid is supplied to the substrate W. However, the present invention is not limited thereto. For example, a gas of the water repellent may be supplied to the substrate W. For example, a vapor of the water repellent may be supplied to the substrate W. Here, the vapor of the water repellent may be supplied to the substrate W together with the vapor of the second solvent. For example, the vapor of the mixed liquid may be supplied to the substrate W. For example, a mist of the water repellent may be supplied to the substrate W.
   The configuration of the seventh supplying unit 15g is appropriately changed according to the change of the water repellent.
(5) In the first and second embodiments, the composition of the second rinse liquid is the same as the composition of the first rinse liquid. However, the present invention is not limited thereto. The composition of the second rinse liquid may be different from the composition of the first rinse liquid.
(6) In the second embodiment, the composition of the third replacement liquid is the same as the composition of the second replacement liquid. However, the present invention is not limited thereto. The composition of the third replacement liquid may be different from the composition of the second replacement liquid.
(7) In the first and second embodiments, the first supplying source 19a generates the drying auxiliary liquid g in the tank 22. However, the present invention is not limited thereto. For example, the first supplying source 19a may generate the drying auxiliary liquid g in a flow path communicating with the first supplying unit 15a.

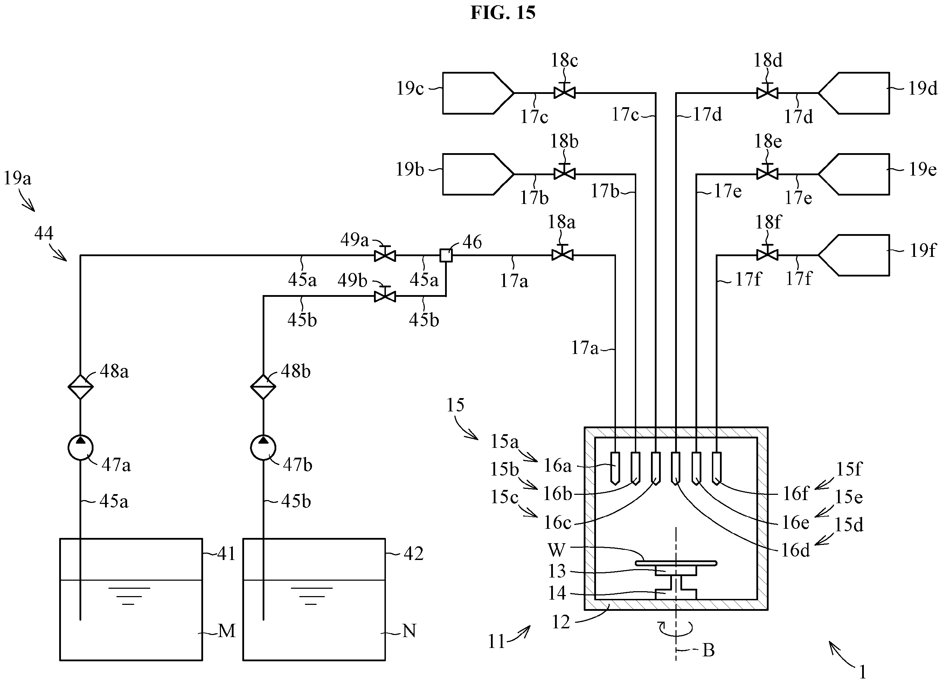

FIG. 15 is a diagram showing the configuration of the treating unit 11 and the first supplying source 19a according to the modification. The same configurations as those of the embodiments are denoted by the same reference signs, and detailed description thereof will be omitted.

The first supplying source 19a includes a first tank 41 and a second tank 42. The first tank 41 stores a sublimable substance M. For example, the first tank 41 may store a solvent together with the sublimable substance M. The second tank 42 stores a first solvent N. For example, the second tank 42 stores only the first solvent N.

The first supplying source 19a includes a mixing unit 44. The mixing unit 44 communicates with the first tank 41 and the second tank 42. The mixing unit 44 generates the drying auxiliary liquid g. The mixing unit 44 further communicates with the first supplying unit 15a. The mixing unit 44 supplies the drying auxiliary liquid g to the first supplying unit 15a.

Specifically, the mixing unit 44 includes pipes 45a and 45b and a joint 46. The pipe 45a communicates with the first tank 41. The pipe 45a is connected to, for example, the first tank 41. The pipe 45b communicates with the second tank 42. The pipe 45b is connected to, for example, the second tank 42. The joint 46 communicates with the pipes 45a and 45b. The joint 46 is connected to, for example, the pipes 45a and 45b.

The joint 46 communicates with the first supplying unit 15a. The joint 46 is connected to the first supplying unit 15a. The joint 46 is connected to, for example, the pipe 17a.

The mixing unit 44 includes pumps 47a and 47b. The pumps 47a and 47b are provided on the pipes 45a and 45b, respectively. The pump 47a sends the sublimable substance M from the first tank 41 to the joint 46 through the pipe 45a. The pump 47b sends the first solvent N from the second tank 42 to the joint 46 through the pipe 45b.

The mixing unit 44 includes filters 48a and 48b. The filters 48a and 48b are provided in the pipes 45a and 45b, respectively. The sublimable substance M passes through the filter 48a. The filter 48a filters the sublimable substance M. The first solvent N passes through the filter 48b. The filter 48b filters the first solvent N.

The mixing unit 44 includes valves 49a and 49b. The valves 49a and 49b are provided on the pipes 45a and 45b, respectively. The valve 49a adjusts the flow rate of the sublimable substance M flowing through the pipe 45a. The valve 49b adjusts the flow rate of the first solvent N flowing through the pipe 45b. The valves 49a and 49b may each include a flow rate regulating valve, for example. The valves 49a and 49b may include, for example, a flow rate regulating valve and an on-off valve, respectively.

An operation example of the first supplying source 19a in the modification will be described. In the first supplying step or the second supplying step, the first supplying source 19a generates the drying auxiliary liquid g and sends the drying auxiliary liquid g to the first supplying unit 15a. Specifically, the valves 49a and 49b open. The pump 47a sends the sublimable substance M from the first tank 41 to the joint 46. The pump 47a pumps the sublimable substance M from the first tank 41 to the joint 46. The pump 47b sends the first solvent N from the second tank 42 to the joint 46. The pump 47b pumps the first solvent N from the second tank 42 to the joint 46. The valve 49a adjusts the flow rate of the sublimable substance M flowing into the joint 46. The valve 49b adjusts the flow rate of the first solvent N flowing into the joint 46. The sublimable substance M and the first solvent N are mixed in the joint 46. The sublimable substance M and the solvent N become the drying auxiliary liquid g in the joint 46. That is, the drying auxiliary liquid g is generated in the joint 46. The mixing ratio R of the drying auxiliary liquid g is adjusted by the valves 49a and 49b. The drying auxiliary liquid g flows from the joint 46 to the first supplying unit 15a. The nozzle 16a dispenses the drying auxiliary liquid g.

The joint 46 corresponds to the "flow path communicating with the first supplying unit 15a" described above.

According to this modification, it is not necessary to store the drying auxiliary liquid g before the drying auxiliary liquid g is supplied to the first supplying unit 15a. Therefore, the mixing ratio R of the drying auxiliary liquid g is accurately managed. Therefore, the substrate W is more appropriately dried.

Further, the first supplying source 19a does not include the tank 22. Thus, the structure of the first supplying source 19a is suitably simplified. The first supplying source 19a is suitably miniaturized.

(8) In the solidified film forming step of the first embodiment, the substrate W is not cooled. In the sublimation step of the first embodiment, the substrate W is not cooled. However, the present invention is not limited thereto. For example, in the solidified film forming step, the substrate W may be cooled. For example, in the sublimation step, the substrate W may be cooled. For example, the substrate W may be cooled in both the solidified film forming step and the sublimation step. Hereinafter, this modification will be described in detail.

### (8-1) Configuration of modification

This modification will be described with reference to the drawings. The same configurations as those of the first embodiment are denoted by the same reference signs, and detailed description thereof will be omitted. The outline of the substrate treating apparatus 1 and the configuration of the first supplying source 19a in this modification are substantially the same as those in the first embodiment. The configuration of the treating unit 11 of this modification will be described.

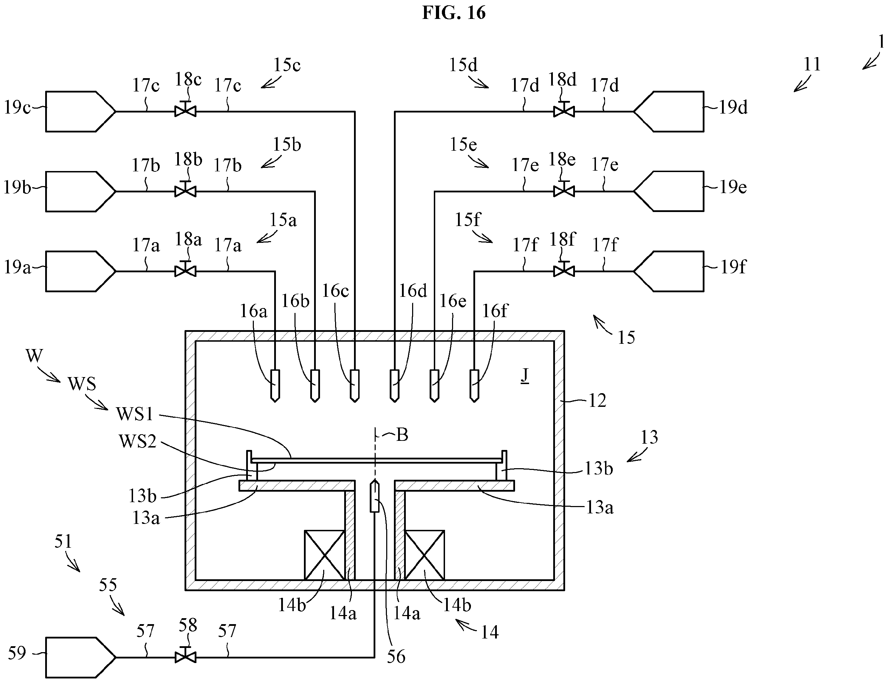

FIG. 16 is a diagram showing the configuration of the treating unit 11 according to the modification. FIG. 16 schematically shows the first supplying source 19a.

The substrate W has a surface WS. The surface WS includes the first surface WS1 and a second surface WS2. The second surface WS2 is located on the opposite side of the first surface WS1. The pattern WP is formed on the first surface WS1. The pattern WP includes the projection T. In FIG. 16, the pattern WP and the projection T are not shown.

The substrate W in a state of being held by the substrate holder 13 will be described. When the substrate W is held by the substrate holder 13, the substrate W is in a substantially horizontal posture. The first surface WS1 faces upward. The first surface WS1 is located on the upper surface of the substrate W. The pattern WP faces upward. The pattern WP is located on the upper surface of the substrate W. The second surface WS2 faces downward. The second surface WS2 is located on the lower surface of the substrate W. The lower surface of the substrate W is also referred to as backside of the substrate W.

A configuration example of the substrate holder 13 will be described. The substrate holder 13 includes a support member 13a. The support member 13a has a plate shape. The support member 13a extends horizontally. Although not shown, the support member 13a has substantially the same size as the substrate W in a plan view. The support member 13a has an annular shape in a plan view. The support member 13a forms an opening. The opening of the support member 13a is located at the center of the support member 13a in a plan view.

The substrate holder 13 includes a plurality of holding pins 13b. Each holding pin 13b is supported by the support member 13a. Each holding pin 13b is disposed at the peripheral edge of the support member 13a. Each holding pin 13b extends upward from the support member 13a. Each holding pin 13b holds the substrate W. When the substrate W is held by the holding pins 13b, the support member 13a is located below the substrate W.

A configuration example of the rotation driving unit 14 will be described. The rotation driving unit 14 includes a shaft 14a and a motor 14b. The shaft 14a is connected to the support member 13a. The shaft 14a extends downward from the support member 13a. The shaft 14a extends on the rotation axis B. The shaft 14a is a so-called hollow shaft. The shaft 14a has a tubular shape. The shaft 14a forms a hollow portion. The hollow portion of the shaft 14a is located inside the shaft 14a. The hollow portion of the shaft 14a is connected to the opening of the support member 13a. The motor 14b is connected to the shaft 14a. The motor 14b rotates the shaft 14a around the rotation axis B.

The treating unit 11 includes a cooling unit 51. The cooling unit 51 cools the substrate W. The cooling unit 51 cools the substrate W held by the substrate holder 13.

The cooling unit 51 cools the second surface WS2 of the substrate W. The cooling unit 51 directly cools the second surface WS2. The cooling unit 51 does not directly cool the first surface WS1.

The cooling unit 51 cools the substrate W to a first cooling temperature. The first cooling temperature is lower than, for example, the temperature of the atmosphere around the substrate W. The first cooling temperature is lower than, for example, the temperature of the atmosphere above the substrate W. The first cooling temperature is lower than the room temperature, for example. When the housing 12 accommodates the substrate W, the room temperature is the temperature of the gas J in the housing 12. The room temperature is, for example, 24 degrees. The first cooling temperature is, for example, 10 degrees or less.

The first cooling temperature is, for example, higher than 0 degrees. The first cooling temperature is, for example, higher than 0 degrees and equal to or lower than 10 degrees.

The cooling unit 51 includes a cooling liquid supplying unit 55. The cooling liquid supplying unit 55 supplies, for example, a cooling liquid to the substrate W. The cooling liquid has, for example, the first cooling temperature. The cooling liquid has, for example, a second cooling temperature. The second cooling temperature is lower than the first cooling temperature. For example, the second cooling temperature is slightly lower than the first cooling temperature. The cooling liquid is, for example, water. The cooling liquid is, for example, deionized water (DIW).

The cooling liquid supplying unit 55 supplies the cooling liquid to, for example, the second surface WS2. The cooling liquid supplying unit 55 does not supply the cooling liquid to the first surface WS1, for example.

A configuration example of the cooling liquid supplying unit 55 will be described. The cooling liquid supplying unit 55 includes a nozzle 56, a pipe 57, and a valve 58. The nozzle 56 dispenses the cooling liquid. The pipe 57 is connected to the nozzle 56. The valve 58 is provided on the pipe 57. When the valve 68 opens, the nozzle 56 dispenses the cooling liquid. When the valve 68 is closed, the nozzle 56 does not dispense the cooling liquid.

The nozzle 56 is installed inside the housing 12. The nozzle 56 is disposed, for example, below the substrate W held by the substrate holder 13. The nozzle 56 is disposed, for example, at the opening of the support member 13a. The nozzle 56 dispenses, for example, the cooling liquid upward. The nozzle 56 dispenses the cooling liquid toward the second surface WS2. The nozzle 56 dispenses the cooling liquid toward the center of the second surface WS2. A part of the pipe 57 is provided inside the housing 12, for example. A part of the pipe 57 is disposed in, for example, for example, the hollow portion of the shaft 14a. Another part of the pipe 57 is provided outside the housing 12, for example. The valve 58 is provided, for example, outside the housing 12.

The cooling liquid supplying unit 55 communicates with a cooling liquid supplying source 59. The cooling liquid supplying source 59 is connected to the cooling liquid supplying unit 55. The cooling liquid supplying source 59 is connected to, for example, the pipe 57. The cooling liquid supplying source 59 is provided outside the housing 12. The cooling liquid supplying source 59 sends the cooling liquid to the cooling liquid supplying unit 55. The cooling liquid supplying source 59 may further adjust the temperature of the cooling liquid. The cooling liquid supplying source 59 may adjust the temperature of the cooling liquid to, for example, the first cooling temperature. The cooling liquid supplying source 59 may adjust the temperature of the cooling liquid to, for example, the second cooling temperature. The cooling liquid supplying source 59 may supply the cooling liquid to the plurality of treating units 11. Alternatively, the cooling liquid supplying source 59 may supply the cooling liquid to only one treating unit 11. The cooling liquid supplying source 59 may be a component of the substrate treating apparatus 1. Alternatively, the cooling liquid supplying source 59 may not be a component of the substrate treating apparatus 1.

It is preferable that the dry gas supplied by the sixth supplying unit 15f has a dew point lower than the first cooling temperature. It is preferable that the dry gas has a dew point lower than the second cooling temperature. The dry gas is, for example, at least one of an air and an inert gas. The air is, for example, compressed air. The inert gas is, for example, nitrogen gas.

### (8-2) Operation example of modification

The substrate treating method of this modification includes Steps S1 and S11 to S19 described in the first embodiment. Therefore, for convenience, reference is made to FIG. 5. The operations of Steps S1 to S16 and S19 are substantially common between the first embodiment and this modification. Therefore, the description of the operations of Steps S1 to S16 and S19 will be omitted. The operations of Steps S17 and S18 will be described.

### Step S17: Solidified film forming step

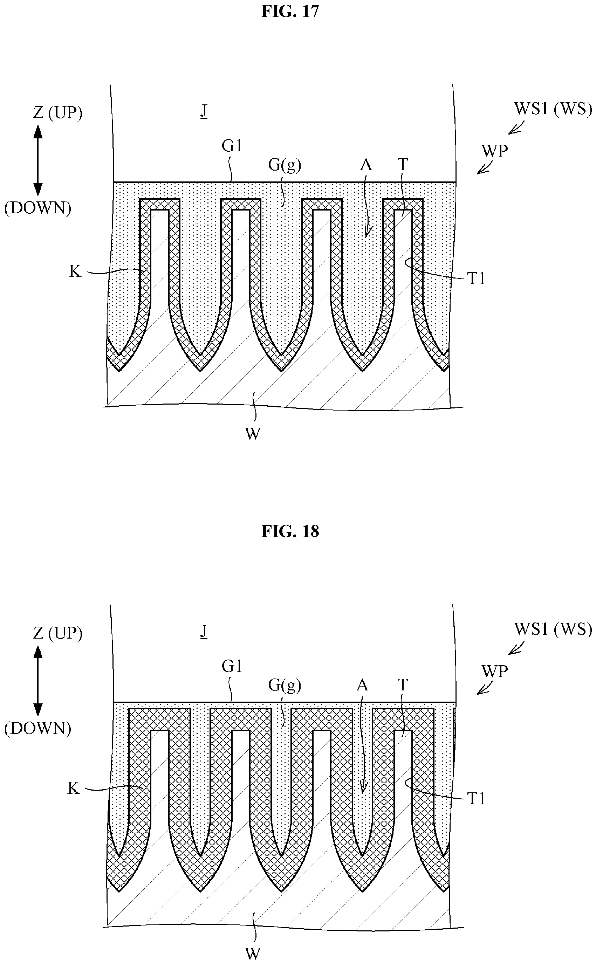

FIG. 17 schematically shows the substrate W in the solidified film forming step of the modification. In the solidified film forming step, the first solvent evaporates from the drying auxiliary liquid g on the substrate W. The drying auxiliary liquid g on the substrate W forms a liquid film G. The drying auxiliary liquid g on the substrate W is referred to as liquid film G as appropriate. In the solidified film forming step, the solidified film K is formed on the substrate W. Further, in the solidified film forming step, the substrate W is cooled.

In the solidified film forming step, the substrate W is cooled to, for example, the first cooling temperature.

In the solidified film forming step, the second surface WS2 is directly cooled. In the solidified film forming step, the substrate W is cooled by the cooling unit 51. Note that the second surface WS2 and the cooling unit 51 are not shown in FIG. 17.

In the solidified film forming step, the substrate W is cooled by supplying the cooling liquid to the substrate W.

Specifically, the cooling liquid supplying unit 55 supplies the cooling liquid to the substrate W held by the substrate holder 13. More specifically, the valve 58 opens. The nozzle 56 dispenses the cooling liquid. The cooling liquid is in contact with the second surface WS2. The cooling liquid flows along the second surface WS2. For example, the cooling liquid flows along the second surface WS2 from the center of the second surface WS2 to the peripheral edge of the second surface WS2. The cooling liquid takes heat from the second surface WS2. The second surface WS2 is directly cooled. The temperature of the second surface WS2 decreases. The temperature of the second surface WS2 is lowered to, for example, the first cooling temperature.

The cooling liquid is not supplied to the first surface WS1 of the substrate W. The cooling liquid is not in contact with the first surface WS1. The first surface WS1 is not directly cooled.

The first surface WS1 is indirectly cooled via the second surface WS2. The temperature of the first surface WS1 decreases. Specifically, the temperature of the pattern WP decreases. The temperature of the projection T decreases. The temperature of the first surface WS1 decreases to, for example, the first cooling temperature.

As a result, the temperature of the first surface WS1 is lower than the temperature of the atmosphere around the substrate W. The temperature of the first surface WS1 is lower than the room temperature. Specifically, the temperature of the first surface WS1 is lower than the temperature of the gas J.

The cooling liquid is not added to the liquid film G. The liquid film G is not directly cooled.

The liquid film G is in contact with the first surface WS1. The liquid film G is indirectly cooled via the first surface WS1.

The interface between the liquid film G and the first surface WS1 is referred to as "solid-liquid interface". The interface between the liquid film G and the gas J is referred to as "gas-liquid interface". The solid-liquid interface is located at the bottom portion of the liquid film G. The gas-liquid interface is located at the upper portion of the liquid film G. The gas-liquid interface is located on the upper surface G1 of the liquid film G. The portion of the liquid film G located in the vicinity of the solid-liquid interface is cooled before the portion of the liquid film G located in the vicinity of the gas-liquid interface is cooled. Therefore, the temperature of the portion of the liquid film G located in the vicinity of the solid-liquid interface is lower than the temperature of the portion of the liquid film G located in the vicinity of the gas-liquid interface.

As the temperature of the treatment liquid g is lower, the sublimable substance in the treatment liquid g solidifies more easily. As the temperature of the treatment liquid g is lower, the sublimable substance in the treatment liquid g precipitates more easily. Therefore, as the temperature of the treatment liquid g is lower, the solidified film K is formed more efficiently. As the temperature of the treatment liquid g is lower, the formation of the solidified film K is further promoted.

Therefore, the portion of the liquid film G located in the vicinity of the solid-liquid interface first changes into the solidified film K. The bottom portion of the liquid film G first changes into the solidified film K. In other words, the portion of the liquid film G located in the vicinity of the solid-liquid interface changes into the solidified film K before the portion of the liquid film G located in the vicinity of the gas-liquid interface changes into the solidified film K. Before the upper portion of the liquid film G is changed into the solidified film K, the bottom portion of the liquid film G changes into the solidified film K. The formation of the solidified film K in the vicinity of the solid-liquid interface is performed before the formation of the solidified film K in the vicinity of the gas-liquid interface. The position where the solidified film K is first generated in the solidified film forming step is, for example, the solid-liquid interface.

The solidified film K is uniformly formed over the entire first surface WS1, for example. The solidified film K is homogeneously formed on the entire first surface WS1, for example. The solidified film K is, for example, uniformly thick over the entire first surface WS1. For example, the solidified film K extends along the first surface WS1. For example, one solidified film K extends over the entire first surface WS1. For example, the solidified film K is not divided into a plurality of portions. For example, the solidified film K does not have a hole portion that exposes the first surface WS1 to the liquid film G or the gas J. The solidified film K covers, for example, the entire first surface WS1. The solidified film K is in contact with, for example, the entire first surface WS1. The first surface WS1 does not have a portion that is in contact with the liquid film G. The first surface WS1 does not have a portion exposed to the liquid film G. The first surface WS1 does not have a portion that is in contact with the gas J. The first surface WS1 does not have a portion exposed to the gas J.

The pattern WP is formed on the first surface WS1. Therefore, the solidified film K is uniformly formed over the entire pattern WP, for example. The solidified film K is homogeneously formed on the entire pattern WP, for example. The solidified film K is, for example, uniformly thick over the entire pattern WP. For example, the solidified film K extends along the pattern WP. For example, one solidified film K extends over the entire pattern WP. For example, the solidified film K is not divided into a plurality of portions. For example, the solidified film K does not have the hole portion that exposes the pattern WP to the liquid film G or the gas J. The solidified film K covers, for example, the entire pattern WP. The solidified film K is in contact with, for example, the entire pattern WP. The pattern WP does not have a portion that is in contact with the liquid film G. The pattern WP does not have a portion exposed to the liquid film G. The pattern WP does not have a portion that is in contact with the gas J. The pattern WP does not have a portion exposed to the gas J.

FIG. 18 schematically shows the substrate W in the solidified film forming step of the modification. The solidified film K further increases. For example, the solidified film K increases from the bottom portion of the liquid film G toward the upper portion of the liquid film G. For example, the solidified film K increases toward the upper surface G1 of the liquid film G.

The solidified film K uniformly increases, for example, over the entire first surface WS1. The solidified film K homogeneously increases, for example, over the entire first surface WS1. The thickness of the solidified film K does not vary excessively, for example, over the entire first surface WS1.

Therefore, the solidified film K uniformly increases, for example, over the entire pattern WP. The solidified film K homogeneously increases, for example, over the entire pattern WP. The thickness of the solidified film K does not vary excessively, for example, over the entire pattern WP.

For convenience, reference is made to FIG. 8. Then, the entire liquid film G disappears from the substrate W. The liquid film G does not remain in the recess A. All of the first solvent disappears from the substrate W. The first solvent also does not remain in the recess A. Only the solidified film K is present on the substrate W. Only the solidified film K is present on the first surface WS1.

### Step S18: Sublimation step

In the sublimation step, the solidified film K is sublimated.

In the sublimation step, the dry gas is supplied to the substrate W. Specifically, the sixth supplying unit 15f supplies the dry gas to the substrate W held by the substrate holder 13. The dry gas is supplied to the first surface WS1. The dry gas is supplied to the solidified film K. The solidified film K is exposed to the dry gas. The solidified film K is suitably sublimated. The solidified film K suitably changes into a gas without being transitioned to a liquid.

The sixth supplying unit 15f is an example of a dry gas supplying unit of the present invention.

Further, in the sublimation step, the substrate W is cooled. The treatment of cooling the substrate W in the sublimation step is substantially the same as the treatment of cooling the substrate W in the solidified film forming step.

In the sublimation step, the substrate W is cooled to, for example, the first cooling temperature. In the sublimation step, the second surface WS2 is directly cooled. In the sublimation step, the substrate W is cooled by the cooling unit 51. In the sublimation step, the substrate W is cooled by supplying the cooling liquid to the substrate W.

For example, the cooling unit 51 keeps cooling the substrate W from the solidified film forming step to the sublimation step. For example, the cooling unit 51 does not interrupt the cooling of the substrate W between the solidified film forming step and the sublimation step.

Specifically, the cooling liquid supplying unit 55 supplies the cooling liquid to the substrate W held by the substrate holder 13. The cooling liquid is supplied to the second surface WS2. The cooling liquid is not supplied to the first surface WS1. The cooling liquid is not supplied to the solidified film K. The second surface WS2 is directly cooled. The first surface WS1 is not directly cooled. The first surface WS1 is indirectly cooled via the second surface WS2. The solidified film K is not directly cooled. The solidified film K is indirectly cooled via the first surface WS1.

The solidified film K is cooled. Therefore, the solidified film K is less likely to melt. That is, the solidified film K is less likely to change into a liquid. Therefore, the solidified film K is more suitably sublimated. The solidified film K more suitably changes into a gas without being transitioned to a liquid.

For convenience, reference is made to FIGS. 9 and 10. The solidified film K is sublimated. The solidified film K is removed from the substrate W by the sublimation of the solidified film K. The substrate W is dried.

Thereafter, the sixth supplying unit 15f stops supplying the dry gas. Specifically, the valve 18f is closed. The nozzle 16f stops blowing out the dry gas. Further, the cooling unit 51 stops cooling the substrate W. Specifically, the cooling liquid supplying unit 55 stops supplying the cooling liquid. More specifically, the valve 58 is closed. The nozzle 56 stops dispensing the cooling liquid.

### (8-3) Technical significance of cooling substrate W

The technical significance of cooling the substrate W will be described by Example 1 and Example 3. Example 1 has been described in "1-6. Technical significance of hydrophilization step" of the first embodiment.

The conditions of Example 3 will be described. The step for treating the substrate W is the same in Example 1 and Example 3. That is, in Example 3, the substrate W is also treated in the etching step, the first rinse step, the hydrophilization step, the second rinse step, the first replacement step, the first supplying step, the solidified film forming step, and the sublimation step. In the solidified film forming step and the sublimation step of Example 3, the substrate W is cooled. The conditions of Example 3 are the same as the conditions of Example 1 except that the substrate W is cooled in the solidified film forming step and the sublimation step. In the solidified film forming step and the sublimation step of Example 1, the substrate W is not cooled.

The substrates W treated in Example 1 and Example 3 were evaluated by collapse rate.

The collapse rate of the substrate W treated in Example 3 was lower than the collapse rate of the substrate W treated in Example 1.

Therefore, in Example 3, the substrate W was dried more appropriately. In Example 3, the pattern WP was protected more appropriately. In Example 3, the collapse of the pattern WP was prevented more appropriately. In Example 3, the substrate W was dried in a state where the pattern WP was more suitably protected. The quality of the treatment in Example 3 was further improved compared to the quality of the treatment in Example 1.

### (8-4) Effects of modification

This modification also has the same effects as the first embodiment. For example, the substrate treating method of this modification includes the hydrophilization step, the first supplying step, the solidified film forming step, and the sublimation step. The sublimable substance contains an organic compound containing an oxime group. Therefore, in the solidified film forming step, the solidified film K is appropriately formed along the pattern WP. Thus, the substrate W is appropriately dried.

Furthermore, this modification has the following effects.

In the solidified film forming step, the substrate W is cooled. Therefore, in the solidified film forming step, the formation of the solidified film K is further promoted. Therefore, the solidified film K is more suitably formed along the pattern WP. Therefore, the substrate W is more appropriately dried.

In the solidified film forming step, the substrate W is cooled to the first cooling temperature. Therefore, the formation of the solidified film K is further promoted.

The first cooling temperature is lower than, for example, the temperature of the atmosphere around the substrate W. Specifically, in the solidified film forming step, the substrate W is cooled to a temperature lower than the temperature of the atmosphere around the substrate W. Therefore, the formation of the solidified film K is further promoted.

The first cooling temperature is lower than the room temperature, for example. Specifically, in the solidified film forming step, the substrate W is cooled to a temperature lower than the room temperature. Therefore, the formation of the solidified film K is further promoted.

The first cooling temperature is lower than that of the gas J, for example. Specifically, in the solidified film forming step, the substrate W is cooled to a temperature lower than the temperature of the gas J in the housing 12 accommodating the substrate W. Therefore, the formation of the solidified film K is further promoted.

The first cooling temperature is, for example, 10 degrees or less. Specifically, in the solidified film forming step, the substrate W is cooled to a temperature of 10 degrees or less. Therefore, the formation of the solidified film K is further promoted.

The first cooling temperature is, for example, higher than 0 degrees. Specifically, in the solidified film forming step, the substrate W is cooled to a temperature higher than 0 degrees. Therefore, the temperature of the substrate W is not excessively low. Therefore, in the solidified film forming step, the atmosphere around the substrate W is less likely to condense on the substrate W. In the solidified film forming step, the gas J is less likely to condense on the substrate W. Therefore, the substrate W is more appropriately dried.

The first cooling temperature is, for example, higher than 0 degrees and equal to or lower than 10 degrees. Specifically, in the solidified film forming step, the substrate W is cooled to a temperature higher than 0 degrees and equal to or lower than 10 degrees. Therefore, the formation of the solidified film K is further promoted. Further, in the solidified film forming step, the atmosphere around the substrate W is less likely to condense on the substrate W. In the solidified film forming step, the gas J is less likely to condense on the substrate W. Therefore, the substrate W is more appropriately dried.

In the solidified film forming step, the second surface WS2 is directly cooled. The second surface WS2 is located on the opposite side of the first surface WS1 on which the pattern WP is formed. Therefore, the formation of the solidified film K in the vicinity of the solid-liquid interface is suitably promoted. Specifically, the solidified film K is efficiently formed on the interface between the first surface WS1 and the drying auxiliary liquid g. Therefore, the solidified film K is formed further suitably along the pattern WP. Therefore, the substrate W is more appropriately dried.

In the solidified film forming step, the substrate W is cooled by supplying the cooling liquid to the substrate W. Therefore, in the solidified film forming step, the substrate W is suitably cooled.

In the sublimation step, the substrate W is cooled. Therefore, in the sublimation step, the solidified film K is suitably sublimated. Therefore, the substrate W is more appropriately dried.

In the sublimation step, the substrate W is cooled to the first cooling temperature. Therefore, the solidified film K is suitably sublimated.

The first cooling temperature is lower than, for example, the temperature of the atmosphere around the substrate W. Specifically, in the sublimation step, the substrate W is cooled to a temperature lower than the temperature of the atmosphere around the substrate W. Therefore, the solidified film K is suitably sublimated.

The first cooling temperature is lower than the room temperature, for example. Specifically, in the sublimation step, the substrate W is cooled to a temperature lower than the room temperature. Therefore, the solidified film K is suitably sublimated.

The first cooling temperature is lower than that of the gas J, for example. Specifically, in the sublimation step, the substrate W is cooled to a temperature lower than the temperature of the gas J in the housing 12 accommodating the substrate W. Therefore, the solidified film K is suitably sublimated.

The first cooling temperature is, for example, 10 degrees or less. Specifically, in the sublimation step, the substrate W is cooled to a temperature of 10 degrees or less. Therefore, the solidified film K is suitably sublimated.

The first cooling temperature is, for example, higher than 0 degrees. Specifically, in the sublimation step, the substrate W is cooled to a temperature higher than 0 degrees. Therefore, the temperature of the substrate W is not excessively low. Therefore, in the sublimation step, the atmosphere around the substrate W is less likely to condense on the substrate W. In the sublimation step, the gas J is less likely to condense on the substrate W. Therefore, the substrate W is more appropriately dried.

The first cooling temperature is, for example, higher than 0 degrees and equal to or lower than 10 degrees. Specifically, in the sublimation step, the substrate W is cooled to a temperature higher than 0 degrees and equal to or lower than 10 degrees. Therefore, the solidified film K is suitably sublimated. Further, in the sublimation step, the atmosphere around the substrate W is less likely to condense on the substrate W. In the sublimation step, the gas J is less likely to condense on the substrate W. Therefore, the substrate W is more appropriately dried.

In the sublimation step, the second surface WS2 is directly cooled. The second surface WS2 is located on the opposite side of the first surface WS1 on which the pattern WP is formed. Therefore, the substrate W is dried in a state where the pattern WP is suitably protected. Therefore, the substrate W is more appropriately dried.

In the sublimation step, the substrate W is cooled by supplying the cooling liquid to the substrate W. Therefore, in the sublimation step, the substrate W is suitably cooled.

In the sublimation step, the dry gas is supplied to the substrate W. Therefore, the solidified film K is suitably sublimated.

The dry gas has, for example, a dew point lower than the first cooling temperature. Therefore, the dry gas is less likely to condense on the substrate W. Therefore, the substrate W is more appropriately dried.

The dry gas has, for example, a dew point lower than the second cooling temperature. Therefore, the dry gas is further less likely to condense on the substrate W.

The dry gas is, for example, an inert gas. Therefore, the dry gas does not condense on the substrate W.

In the sublimation step, the dry gas is supplied to the first surface WS1. Therefore, the condensation on the first surface WS1 is suitably prevented. Therefore, the condensation on the pattern WP is suitably prevented. Therefore, the substrate W is more appropriately dried.

The substrate treating apparatus 1 includes the cooling unit 51. The cooling unit 51 cools the substrate W. Therefore, the substrate W is suitably cooled. Therefore, the substrate W is treated more appropriately.

The cooling unit 51 directly cools the second surface WS2. Therefore, the substrate W is cooled more suitably. Therefore, the substrate W is treated more appropriately.

The cooling unit 51 includes the cooling liquid supplying unit 55. The cooling liquid supplying unit 55 supplies the cooling liquid to the substrate W. Therefore, the cooling unit 51 suitably cools the substrate W.

The cooling liquid supplying unit 55 supplies the cooling liquid to the second surface WS2. Therefore, the cooling unit 51 suitably cools the second surface WS2.

The cooling liquid supplying unit 55 includes the nozzle 56. The nozzle 56 dispenses the cooling liquid. Therefore, the cooling liquid supplying unit 55 suitably supplies the cooling liquid to the substrate W.

When the substrate W is held by the substrate holder 13, the second surface WS2 faces downward. The nozzle 56 is disposed below the substrate W held by the substrate holder 13. Therefore, the cooling liquid supplying unit 55 suitably supplies the cooling liquid to the second surface WS2.

In the solidified film forming step, the cooling unit 51 cools the substrate W. Therefore, the formation of the solidified film K is further promoted. Therefore, the solidified film K is more suitably formed along the pattern WP. Therefore, the substrate W is more appropriately dried.

In the sublimation step, the cooling unit 51 cools the substrate W. Therefore, the solidified film K is suitably sublimated. Therefore, the substrate W is more appropriately dried.

The substrate treating apparatus 1 includes the sixth supplying unit 15f. The sixth supplying unit 15f supplies the dry gas to the substrate W. The dry gas is less likely to condense on the substrate W. Therefore, the substrate W is more appropriately dried.

The sixth supplying unit 15f supplies the dry gas to the first surface WS1. Therefore, the condensation on the first surface WS1 is suitably prevented. Therefore, the condensation on the pattern WP is suitably prevented. Therefore, the substrate W is treated more appropriately.

In the sublimation step, the sixth supplying unit 15f supplies the dry gas to the substrate W. Therefore, the solidified film K is suitably sublimated. Thus, the substrate W is appropriately dried. Further, the dry gas is less likely to condense on the substrate W. Therefore, the substrate W is more appropriately dried.

### (8-5) Further modified example of modification

The cooling unit 51 of the modification described above includes the cooling liquid supplying unit 55. However, the present invention is not limited thereto. The cooling unit 51 may include at least one of the cooling liquid supplying unit 55, a cooling gas supplying unit, and a cooling plate.

The cooling gas supplying unit will be described. The cooling gas supplying unit supplies a cooling gas to the substrate W. The substrate W is cooled by the cooling gas. The cooling gas supplying unit cools the substrate W to, for example, the first cooling temperature. The cooling gas has, for example, the first cooling temperature. The cooling gas has, for example, the second cooling temperature. The second cooling temperature is lower than the first cooling temperature. The cooling gas is, for example, at least one of an air and an inert gas. It is preferable that the cooling gas has a dew point lower than the first cooling temperature. It is preferable that the cooling gas has a dew point lower than the second cooling temperature.

The cooling gas supplying unit supplies, for example, the cooling gas to the second surface WS2. The cooling gas is in contact with, for example, the second surface WS2. For example, the cooling gas flows along the second surface WS2. For example, the cooling gas takes heat from the second surface WS2.

The cooling gas supplying unit does not supply the cooling gas to the first surface WS1, for example.

The cooling gas supplying unit includes, for example, a nozzle. The nozzle of the cooling gas supplying unit blows out the cooling gas. The nozzle of the cooling gas supplying unit is disposed below the substrate W held by the substrate holder 13. For example, the nozzle of the cooling gas supplying unit may be the nozzle 56. That is, the cooling gas supplying unit and the cooling liquid supplying unit 55 may share the nozzle 56. The nozzle 56 may dispense the cooling liquid and may dispense the cooling gas. Alternatively, the nozzle of the cooling gas supplying unit may be a member different from the nozzle 56.

The cooling gas supplying unit may further include a pipe and a valve. The pipe is connected to the nozzle. The pipe sends the cooling gas to the nozzle. The valve is provided on the pipe. The valve controls the dispense of the cooling gas.

The cooling plate will be described. The cooling plate is in contact with the substrate W. The substrate W is cooled by the cooling plate. The cooling plate cools the substrate W to, for example, the first cooling temperature. The cooling plate has, for example, the first cooling temperature. The cooling plate has, for example, the second cooling temperature. The second cooling temperature is lower than the first cooling temperature.

The substrate W is mounted on the cooling plate. The cooling plate is in contact with, for example, the second surface WS2. The cooling plate is in surface contact with, for example, the second surface WS2. The cooling plate is in contact with, for example, the entire second surface WS2. For example, the cooling plate takes heat from the second surface WS2.

The cooling plate is not in contact with, for example, the first surface WS1.

The cooling unit 51 may further include a configuration for adjusting the temperature of the cooling plate. For example, the cooling unit 51 may include a flow path. The flow path is formed, for example, inside the cooling plate. For example, a heat medium fluid flows through the flow path. The heat medium fluid adjusts the temperature of the cooling plate. For example, the cooling unit 51 may include a heat exchanger. The heat exchanger adjusts the temperature of the cooling plate. The heat exchanger is, for example, attached to the cooling plate. For example, the cooling unit 51 may include a Peltier element. The Peltier element adjusts the temperature of the cooling plate. For example, the Peltier element is attached to the cooling plate.

The cooling plate is disposed below the substrate W held by the substrate holder 13. The cooling plate may be rotatably provided. For example, the cooling plate may rotate about the axis B. Alternatively, the cooling plate may be provided to be non-rotatable. For example, the cooling plate may be fixed to the housing 12. The cooling plate may be provided to be movable in the vertical direction Z with respect to the substrate W held by the substrate holder 13. Alternatively, the cooling plate may be provided to be non-movable in the vertical direction Z with respect to the substrate W held by the substrate holder 13. The cooling plate may be, for example, at least a part of the substrate holder 13. The cooling plate may be, for example, at least a part of the support member 13a. Alternatively, the cooling plate may be a member separate from the substrate holder 13.

In the sublimation step of the modification described above, the substrate W is cooled. However, the present invention is not limited thereto. For example, the substrate W may not be cooled in at least a part of the period of the sublimation step. For example, the cooling of the substrate W may be ended before the sublimation step ends.

In the first supplying step of the modification described above, the substrate W is not cooled. However, the present invention is not limited thereto. For example, the substrate W may be cooled in at least a part of the period of the first supplying step. For example, the cooling of the substrate W may be started before the first supplying step ends. For example, the cooling of the substrate W may be started before the solidified film forming step is started.

In the modification described above, the substrate W is treated in the housing 12 in the solidified film forming step. The treating unit 11 that performs the solidified film forming step is the same as the treating unit 11 that performs the first supplying step. However, the present invention is not limited thereto. In the solidified film forming step, the substrate W may be treated outside the housing 12. The treating unit that performs the solidified film forming step may be different from the treating unit 11 that performs the first supplying step. The configuration of the treating unit that performs the solidified film forming step may be different from the configuration of the treating unit 11 that performs the first supplying step. The treating unit 11 that performs the first supplying step may not include, for example, the cooling unit 51. The treating unit that performs the solidified film forming step may include, for example, the cooling unit. In this case, the cooling unit provided in the treating unit that performs the solidified film forming step cools the substrate W in the treating unit that performs the solidified film forming step. The cooling unit provided in the treating unit that performs the solidified film forming step does not cool the substrate W held by the substrate holder 13.

In the modification described above, the substrate W is treated in the housing 12 in the sublimation step. The treating unit 11 that performs the sublimation step is the same as the treating unit 11 that performs the first supplying step. However, the present invention is not limited thereto. In the sublimation step, the substrate W may be treated outside the housing 12. The treating unit that performs the sublimation step may be different from the treating unit 11 that performs the first supplying step. The configuration of the treating unit that performs the sublimation step may be different from the configuration of the treating unit 11 that performs the first supplying step. The treating unit 11 that performs the first supplying step may not include, for example, the cooling unit 51. The treating unit that performs the sublimation step may include, for example, the cooling unit. In this case, the cooling unit provided in the treating unit that performs the sublimation step cools the substrate W in the treating unit that performs the sublimation step. The cooling unit provided in the treating unit that performs the sublimation step does not cool the substrate W held by the substrate holder 13.

In the solidified film forming step of the modification described above, the substrate W may be treated in an atmosphere composed of the dry gas. In the solidified film forming step, the substrate W may be treated in an atmosphere composed of only the dry gas. In the solidified film forming step, the gas J in the housing 12 may be composed of only the dry gas. In the solidified film forming step, the housing 12 may be sealed. In the solidified film forming step, the inside of the housing 12 may be shielded from the outside of the housing 12. Thus, in the solidified film forming step, the condensation on the substrate W is more suitably prevented.

In the sublimation step of the modification described above, the substrate W may be treated in an atmosphere composed of the dry gas. In the sublimation step, the substrate W may be treated in an atmosphere composed only of the dry gas. In the sublimation step, the gas J in the housing 12 may be composed of only the dry gas. In the sublimation step, the housing 12 may be sealed. In the sublimation step, the inside of the housing 12 may be shielded from the outside of the housing 12. Thus, in the sublimation step, the condensation on the substrate W is more suitably prevented.

(9) The substrate treating method of the first embodiment includes the etching step, the first rinse step, the second rinse step, and the first replacement step. However, the present invention is not limited thereto. For example, at least one of the etching step, the first rinse step, the second rinse step, and the first replacement step may be omitted. For example, all of the etching step, the first rinse step, the second rinse step, and the first replacement step may be omitted.

(10) The substrate treating method of the second embodiment includes the etching step, the first rinse step, the hydrophilization step, the second rinse step, the second replacement step, and the third replacement step. However, the present invention is not limited thereto. For example, at least one of the etching step, the first rinse step, the hydrophilization step, the second rinse step, the second replacement step, and the third replacement step may be omitted. For example, all of the etching step, the first rinse step, the hydrophilization step, the second rinse step, the second replacement step, and the third replacement step may be omitted.

(11) In the first embodiment, a liquid (for example, the first replacement liquid) is present on the substrate W when the first supplying step is started. That is, in the first supplying step, the drying auxiliary liquid g is supplied to the substrate W which is in an undried state. However, the present invention is not limited thereto. For example, when the first supplying step is started, a liquid (for example, the first replacement liquid) may not be present on the substrate W. For example, in the first supplying step, the drying auxiliary liquid g may be supplied to the substrate W which is in a dried state.

Similarly, in the second embodiment, a liquid (for example, the third replacement liquid) is present on the substrate W when the second supplying step is started. That is, in the second supplying step, the drying auxiliary liquid g is supplied to the substrate W which is in an undried state. However, the present invention is not limited thereto. For example, when the second supplying step is started, a liquid (for example, the third replacement liquid) may not be present on the substrate W. For example, in the second supplying step, the drying auxiliary liquid g may be supplied to the substrate W which is in a dried state.

(12) In the first supplying step of the first embodiment, the drying auxiliary liquid g removes the first replacement liquid from the substrate W. In the second supplying step of the second embodiment, the drying auxiliary liquid g removes the third replacement liquid from the substrate W. However, the present invention is not limited thereto. For example, in at least one of the first supplying step and the second supplying step, the drying auxiliary liquid g may clean the substrate W. For example, in at least one of the first supplying step and the second supplying step, the drying auxiliary liquid g may remove foreign matters adhering to the substrate W. For example, in at least one of the first supplying step and the second supplying step, the drying auxiliary liquid g may dissolve foreign matters adhering to the substrate W. The foreign matters are, for example, resist residues.

(13) In the solidified film forming step of the first and second embodiments, the dry gas is not supplied to the substrate W. However, the present invention is not limited thereto. In the solidified film forming step, the dry gas may be supplied to the substrate W. In the solidified film forming step, the dry gas may be supplied to the drying auxiliary liquid g on the substrate W. According to this modification, the drying auxiliary liquid g on the substrate W is exposed to the dry gas in the solidified film forming step. Therefore, in the solidified film forming step, the solvent efficiently evaporates from the drying auxiliary liquid g on the substrate W. In the solidified film forming step, the solidified film K is efficiently formed on the substrate W.

(14) In the first and second embodiments, the pattern WP on the substrate W may be formed on the substrate W before the treating unit 11 treats the substrate W, for example. Alternatively, the pattern WP may be formed on the substrate W in, for example, the etching step (Step S11).

(15) The first and second embodiments and the modifications described in (1) to (14) above may be appropriately changed by replacing or combining, etc. the configurations with the configurations of other modifications.

### Reference Signs List

- 1: substrate treating apparatus
- 10: controller
- 11: treating unit
- 13: substrate holder
- 15: supplying unit
- 15a: first supplying unit
- 15c: third supplying unit (hydrophilization unit)
- 15f: sixth supplying unit (dry gas supplying unit)
- 15g: seventh supplying unit (hydrophilization unit)
- 51: cooling unit
- g: drying auxiliary liquid
- G: liquid film of drying auxiliary liquid
- G1: upper surface of liquid film
- J: gas
- K: solidified film
- K1: upper surface of solidified film
- L: interface between side of projection and drying auxiliary liquid
- L1: first section
- L2: second section
- M: sublimable substance
- N: first solvent
- W: substrate
- WS: surface of substrate
- WS1: first surface of surface of substrate
- WP: pattern
- T: projection
- T1: side of projection
- A: recess

## Claims

1. A substrate treating method for treating a substrate having a pattern formed on a surface of the substrate, the substrate treating method comprising:
a hydrophilization step of forming a hydroxy group on the surface of the sub strate;
a first supplying step of supplying a drying auxiliary liquid containing a sublimable substance and a first solvent to the substrate having the hydroxy group;
a solidified film forming step of forming a solidified film containing the sublimable substance on the substrate by evaporating the first solvent from the drying auxiliary liquid on the substrate; and
a sublimation step of sublimating the solidified film, wherein
the sublimable substance contains an organic compound containing an oxime group.

2. The substrate treating method according to claim 1, wherein in the hydrophilization step, an ammonia hydrogen peroxide mixture is supplied to the substrate.

3. The substrate treating method according to claim 1, further comprising an etching step of supplying an etching liquid to the substrate to remove an oxide film on the substrate before the hydrophilization step.

4. The substrate treating method according to claim 3, further comprising a first rinse step of supplying a first rinse liquid to the substrate after the etching step and before the hydrophilization step.

5. The substrate treating method according to claim 1, further comprising a second rinse step of supplying a second rinse liquid to the substrate after the hydrophilization step and before the first supplying step.

6. The substrate treating method according to claim 5, further comprising a first replacement step of supplying a first replacement liquid to the substrate after the second rinse step and before the first supplying step.

7. The substrate treating method according to claim 1, wherein in the solidified film forming step, the substrate is cooled.

8. The substrate treating method according to claim 1, wherein the sublimable substance does not contain a fluorocarbon compound.

9. The substrate treating method according to claim 1, wherein the sublimable substance contains at least one of cyclohexanone oxime and pinacoline oxime.

10. A substrate treating method for treating a substrate having a pattern formed on a surface of the substrate, the substrate treating method comprising:
a hydrophobization step of adhering a water repellent to the surface of the sub strate;
a second supplying step of supplying a drying auxiliary liquid containing a sublimable substance and a first solvent to the substrate to which the water repellent adheres;
a solidified film forming step of forming a solidified film containing the sublimable substance on the substrate by evaporating the first solvent from the drying auxiliary liquid on the substrate; and
a sublimation step of sublimating the solidified film, wherein
the sublimable substance contains an organic compound containing an oxime group.

11. The substrate treating method according to claim 10, wherein in the hydrophobization step, a mixed liquid containing the water repellent and a second solvent is supplied to the substrate.

12. The substrate treating method according to claim 10, further comprising a hydrophilization step of forming a hydroxy group on the surface of the substrate before the hydrophobization step.

13. The substrate treating method according to claim 12, further comprising an etching step of supplying an etching liquid to the substrate to remove an oxide film on the substrate before the hydrophilization step.

14. The substrate treating method according to claim 13, further comprising a first rinse step of supplying a first rinse liquid to the substrate after the etching step and before the hydrophilization step.

15. The substrate treating method according to claim 12, further comprising a second rinse step of supplying a second rinse liquid to the substrate after the hydrophilization step and before the hydrophobization step.

16. The substrate treating method according to claim 15, further comprising a second replacement step of supplying a second replacement liquid to the substrate after the second rinse step and before the hydrophobization step.

17. The substrate treating method according to claim 10, further comprising a third replacement step of supplying a third replacement liquid to the substrate after the hydrophobization step and before the second supplying step.

18. The substrate treating method according to claim 10, wherein the sublimable substance does not contain a fluorocarbon compound.

19. The substrate treating method according to claim 10, wherein the sublimable substance contains at least one of cyclohexanone oxime and pinacoline oxime.

20. A substrate treating apparatus comprising:
a substrate holder that holds a substrate;
a hydrophilization unit that forms a hydroxy group on a surface of the substrate held by the substrate holder; and
a first supplying unit that supplies a drying auxiliary liquid containing a sublimable substance and a first solvent to the substrate held by the substrate holder, wherein
the sublimable substance contains an organic compound containing an oxime group.

21. The substrate treating apparatus according to claim 20, further comprising a cooling unit that cools the substrate.

22. A substrate treating apparatus comprising:
a substrate holder that holds a substrate;
a hydrophobization unit that adheres a water repellent to a surface of the substrate held by the substrate holder; and
a first supplying unit that supplies a drying auxiliary liquid containing a sublimable substance and a first solvent to the substrate held by the substrate holder, wherein
the sublimable substance contains an organic compound containing an oxime group.
